# EUROPEAN PATENT APPLICATION

(11) **EP 4 471 777 A1**
(43) Date of publication of application: **04.12.2024**
(21) Application number: 24178671.4
(22) Date of filing: 29.05.2024
(51) Int. Cl.: G11C 11/406, G11C 11/408

(54) **MEMORY DEVICE AND METHOD OF OPERATING THE SAME**

(30) Priority: 01.06.2023 KR 20230071163; 04.10.2023 KR 20230132061
(71) Applicant: Samsung Electronics Co., Ltd., Suwon-si, Gyeonggi-do 16677 (KR)
(72) Inventor: KIM, Ki-Heung, 16677 Suwon-si, Gyeonggi-do (KR); OH, Taeyoung, 16677 Suwon-si, Gyeonggi-do (KR); KIM, Jongcheol, 16677 Suwon-si, Gyeonggi-do (KR); LEE, Kyung-Ho, 16677 Suwon-si, Gyeonggi-do (KR); HWANG, Hyongryol, 16677 Suwon-si, Gyeonggi-do (KR)
(74) Representative: Kuhnen & Wacker Patent- und Rechtsanwaltsbüro PartG mbB

(57) **Abstract**

An example memory device 200 includes a memory cell array 310, a row hammer management circuit 500, and a read-modify-write (RMW) driver 600. The memory cell array 310 includes a plurality of memory cell rows and stores count data for a number of accesses to each memory cell row. The row hammer management circuit 500 performs an RMW operation that reads out count data corresponding to a target memory cell row among the memory cell rows, updates the read-out count data, and writes the updated count data in the memory cell array 310. The RMW driver 600 generates control signals to control the RMW operation based on a precharge command. The target memory cell row is precharged after a predetermined time is elapsed from a time point where the precharge command is applied.

## Description

### BACKGROUND

Memory devices are used to store data and classified into volatile memory devices and nonvolatile memory devices. A volatile memory device is a memory device that loses its stored data when the power supply is interrupted. Among volatile memory devices, dynamic random access memories (DRAMs) are used in various fields, such as a mobile system, a server, a graphics unit, etc.

Volatile memory devices, such as DRAM, determine data based on electric charge stored in a capacitor. However, since electric charge stored in a capacitor gradually leaks away in various ways, volatile memory devices need to periodically perform refresh operations.

Meanwhile, when a specific memory cell row is intensively accessed, a row hammer phenomenon occurs, leading to the loss of data stored in memory cells included in a memory cell row adjacent to the specific memory cell row. Accordingly, the number of accesses to each memory cell row is required to be effectively handled to prevent the occurrence of the row hammer phenomenon.

### SUMMARY

The present disclosure relates to memory devices, including a memory device capable of effectively handling the number of access to each memory cell.

According to the above, the memory device effectively manages the number of accesses to each memory cell row using the precharge command.

### BRIEF DESCRIPTION OF THE DRAWINGS

The above and other objects and features of the present disclosure will become apparent by describing in detail implementations thereof with reference to the accompanying drawings.
FIG. 1 is a block diagram illustrating an example of a memory device.
FIG. 2A is a block diagram illustrating an example of a read-modify-write (RMW) driver.
FIG. 2B is a block diagram illustrating an example of a read-modify-write (RMW) driver.
FIG. 3 is a view illustrating an example of a precharge command.
FIG. 4 is a flowchart illustrating an example of an operation of a memory device.
FIG. 5 is a block diagram illustrating an example of a memory system.
FIG. 6 is a block diagram illustrating an example of a configuration of a memory controller.
FIG. 7 is a block diagram illustrating an example of a memory device.
FIG. 8 is a view illustrating an example of a bank array.
FIG. 9 is a diagram illustrating an example of an operation of generating an inner precharge signal.
FIG. 10 is a view illustrating an example of an arrangement of a memory device.
FIGS. 11A and 11B are diagrams illustrating an example of an operation of an IACU generator of an RMW driver.
FIGS. 12, 13A, and 13B are diagrams illustrating an example of a configuration and operation of an RMW control circuit of an RMW driver.
FIG. 14A is a view illustrating an example of a bank array.
FIG. 14B is a view illustrating an example of a bank array.
FIG. 15 is a view illustrating an example of a bank array.
FIG. 16 is a block diagram illustrating an example of a bank array and a sense amplifier.
FIG. 17 is a diagram illustrating an example of a portion of a first bank array of FIG. 16.
FIG. 18 is a circuit diagram illustrating an example of a bit-line sense amplifier of FIG. 17.
FIG. 19 is a block diagram illustrating an example of a memory device that performs a normal read or write operation.
FIG. 20 is a block diagram illustrating an example of a memory device that performs an RMW operation.
FIG. 21 is a flowchart illustrating an example of an operation of a memory device.
FIG. 22A is a block diagram illustrating an example of a memory system.
FIG. 22B is a block diagram illustrating an example of a control logic circuit of FIG. 22A.
FIG. 23A is a block diagram illustrating an example of a memory system.
FIG. 23B is a block diagram illustrating an example of a control logic circuit of FIG. 23A.

### DETAILED DESCRIPTION

Below, implementations of the present disclosure will be described in detail and clearly to such an extent that an ordinary one in the art easily implements the disclosure.

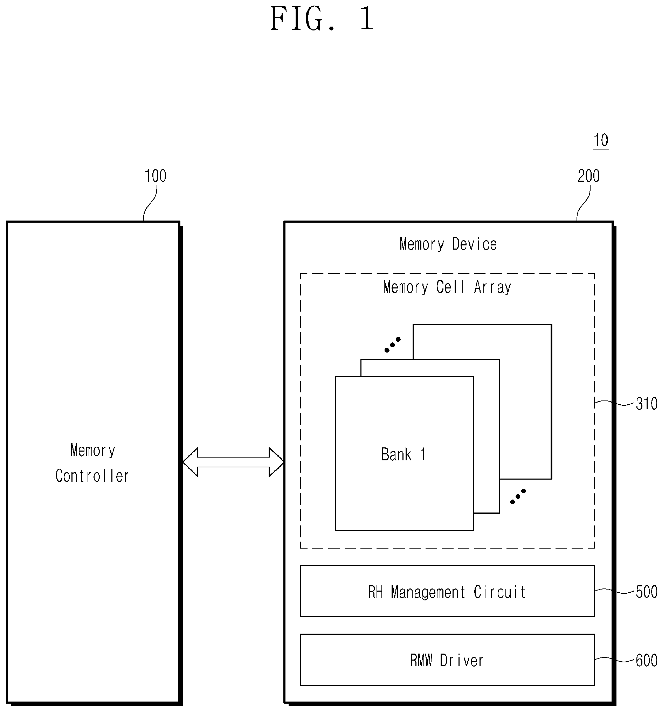

FIG. 1 is a block diagram illustrating an example of a memory system 10.

The memory system 10 may manage the number of accesses to each memory cell row to prevent a row hammer phenomenon that occurs due to intensive accesses to a specific memory cell row. To this end, a memory device 200 may perform a read-modify-write (hereinafter, referred to as an "RMW") operation that read outs count data corresponding to a target memory cell row in an active state, modifies the read-out count data, and writes again the modified count data. That is, the memory device 200, through the RMW operation, may read out the count data corresponding to the target memory cell row that is in the active state, may modify the read-out count data, and may write the modified count data again to update the count data, and thus may manage the number of accesses to each of the memory cell rows.

In this case, the memory device 200 may perform the RMW operation based on a precharge command received from a memory controller 100. The precharge command according to the present implementation may be issued earlier than a normal precharge command by a predetermined time amount. The memory device 200 may perform the RMW operation based on the precharge command and then may perform a precharge operation. As described above, the memory device 200 according to the present implementation may effectively perform the RMW operation without defining a separate dedicated command for the RMW operation between the memory controller 100 and the memory device 200.

Referring to FIG. 1, the memory system 10 may include the memory controller 100 and the memory device 200.

The memory controller 100 may control the memory device 200. As an example, the memory controller 100 may control the memory device 200 in response to a request of a processor supporting various applications, such as a server application, a personal computer (PC) application, a mobile application, etc. For example, the memory controller 100 may be included in a host including a processor and may control the memory device 200 in response to a request of the processor.

The memory controller 100 may transmit a command and/or an address to the memory device 200 to control the memory device 200. In addition, the memory controller 100 may transmit data to the memory device 200 or may receive data from the memory device 200.

The memory device 200 may receive the data from the memory controller 100 and may store the data. The memory device 200 may read out the stored data in response to a request of the memory controller 100 and may transmit the read-out data to the memory controller 100.

In some implementations, the memory device 200 may be a memory device including volatile memory cells. As an example, the memory device 200 may be various DRAM devices such as a double data rate synchronous dynamic random access memory (DDR SDRAM), DDR2 SDRAM, DDR3 SDRAM, DDR4 SDRAM, DDR5 SDRAM, a low power double data rate (LPDDR) SDRAM, LPDDR2 SDRAM, LPDDR3 SDRAM, LPDDR4 SDRAM, LPDDR4X SDRAM, LPDDR5 SDRAM, a graphics double data rate synchronous graphics random access memory (GDDR SGRAM), GDDR2 SGRAM, GDDR3 SGRAM, GDDR4 SGRAM, GDDR5 SGRAM, GDDR6 SGRAM, etc.

In some implementations, the memory device 200 may be a memory device in which DRAM dies are stacked, such as a high bandwidth memory (HBM), HBM2, HBM3, etc.

In some implementations, the memory device 200 may be a memory module such as a dual in-line memory module (DIMM). For example, the memory device 200 may be a registered DIMM (RDIMM), a load reduced DIMM (LRDIMM), an unbuffered DIMM (UDIMM), a fully buffered DIMM (FB-DIMM), or a small outline DIMM (SO-DIMM), however, this is merely an example. In some implementations, the memory device 200 may be any other memory module (e.g., a single in-line memory module (SIMM)).

In some implementations, the memory device 200 may be an SRAM device, a NAND flash memory device, a NOR flash memory device, a RRAM device, a FRAM device, a TRAM device, an MRAM device, etc.

The memory device 200 may include a memory cell array 310, a row hammer (RH) management circuit 500, and an RMW driver 600.

The memory cell array 310 may include a plurality of banks Bank 1 to Bank n, and each of the banks Bank 1 to Bank n may include memory cells to store the data. In the present disclosure, for the convenience of explanation, it is assumed that each bank includes DRAM cells, however, this is merely an example. In some implementations, each of the banks Bank 1 to Bank n may be implemented to include the volatile memory cells in addition to the DRAM cells. In addition, the banks Bank 1 to Bank n may be implemented to include the same types of memory cells or may be implemented to include different types of memory cells.

The memory cell array 310 may include a plurality of memory cell rows. Here, the memory cell row may refer to memory cells included in one row.

In some implementations, the memory cell row may be defined for each bank. As an example, one bank may be connected to a plurality of word lines, and the memory cells connected to the same word line may constitute the same memory cell row. In this case, each bank may include the plural memory cell rows.

In some implementations, the memory cell row may be defined for each sub-array block. As an example, one bank may include a plurality of sub-array blocks, the memory cells connected to the same word line among the memory cells of each sub-array block may constitute the same memory cell row. In this case, each sub-array block may include the plural memory cell rows.

In some implementations, the memory cell row may be defined to include memory cells of different banks from each other. As an example, two or more banks may share the same word lines, and the memory cells connected to the same word line and included in different banks from each other may constitute the same memory cell row, however, this is merely an example. In some implementations, the memory cell row may be defined in various ways.

Some of the memory cells of the memory cell row may be used as a count cell. Here, the count cell may refer to a memory cell that stores the number of accesses to a corresponding memory cell row as count data. Each of the memory cell rows may include the count cell, however, this is merely an example. In some implementations, only some of the memory cell rows may include the count cell. In some implementations, the count cells respectively corresponding to the memory cell rows may be provided in a separate bank.

The row hammer management circuit 500 may manage the number of accesses to each of the memory cell rows based on the command applied thereto from the memory controller 100. As an example, when the active command is issued from the memory controller 100 and the word line is activated, the row hammer management circuit 500 may count the number of accesses to the target memory cell row corresponding to the activated word line. Then, the row hammer management circuit 500 may store the count data, which is the number of accesses, into the count cell corresponding to the target memory cell row.

In some implementations, the row hammer management circuit 500 may manage the number of accesses to each of the memory cell rows through the RMW operation. As an example, when an active command with respect to the target memory cell row is issued from the memory controller 100, the row hammer management circuit 500 may perform the RMW operation that read outs the count data from the count cell of the target memory cell row, adds ` 1' to the read-out count data to generate updated count data, and writes the updated count data again into the count cell of the target memory cell row.

In some implementations, the row hammer management circuit 500 may perform the RMW operation based on the precharge command applied thereto from the memory controller 100. That is, the precharge command may be used not only as a command to precharge the word line of the target memory cell row but also as a command to update the number of accesses to the target memory cell row. Accordingly, there is no need to define a separate dedicated command to perform the RMW operation between the memory controller 100 and the memory device 200, and thus, a complexity of protocol between the memory controller 100 and the memory device 200 may be improved.

In some implementations, the memory device 200 may perform the RMW operation and the precharge operation based on the precharge command, and the RMW operation may be performed prior to the precharge operation.

As an example, when the precharge command is issued from the memory controller 100, the row hammer management circuit 500 may perform the RMW operation on the target memory cell row for a predetermined time based on the precharge command. Here, the predetermined time to perform the RMW operation may be referred to as an active count update time. After the active count update time elapses, the memory device 200 may perform the precharge operation on the target memory cell row.

The RMW driver 600 may generate signals required to perform the RMW operation in response to the precharge command applied thereto from the memory controller 100. In particular, when precharge commands with respect to different banks are received continuously from the memory controller 100, the RMW driver 600 may generate the signals required to perform the RMW operation for each bank. Therefore, each bank may perform the RMW operation in parallel, and as a result, the RMW operation may be effectively performed on different banks from each other.

In some implementations, the RMW driver 600 may generate an internal active count update signal based on the precharge command. In particular, when the precharge commands with respect to different banks are continuously received, the RMW driver 600 may generate the internal active count update signal for each bank.

In some implementations, the RMW driver 600 may generate core signals to control the RMW operation based on the internal active count update signal. As an example, the core signals may include an input/output (I/O) sense amplifier enable signal, a column select line enable signal, etc.

In particular, when the precharge commands with respect to different banks are continuously received, the RMW driver 600 may generate core control signals for each bank based on the internal active count update signal for each bank. Accordingly, when the precharge commands with respect to different banks are continuously received, the RMW operation for each bank may be performed in parallel. Therefore, even though the precharge commands with respect to different banks are received continuously at short time intervals, the RMW operation for each bank may be performed effectively without performance degradation.

As described above, the memory device 200 may perform the RMW operation based on the precharge command without the need to define a separate dedicated command for the RMW operation between the memory controller 100 and memory device 200. In addition, even when the precharge commands with respect to different banks are continuously received, the memory device 200 may perform the RMW operation for each bank in parallel. Accordingly, the RMW operation may be performed without degrading the performance and increasing the complexity of the protocol between the memory controller 100 and the memory device 200.

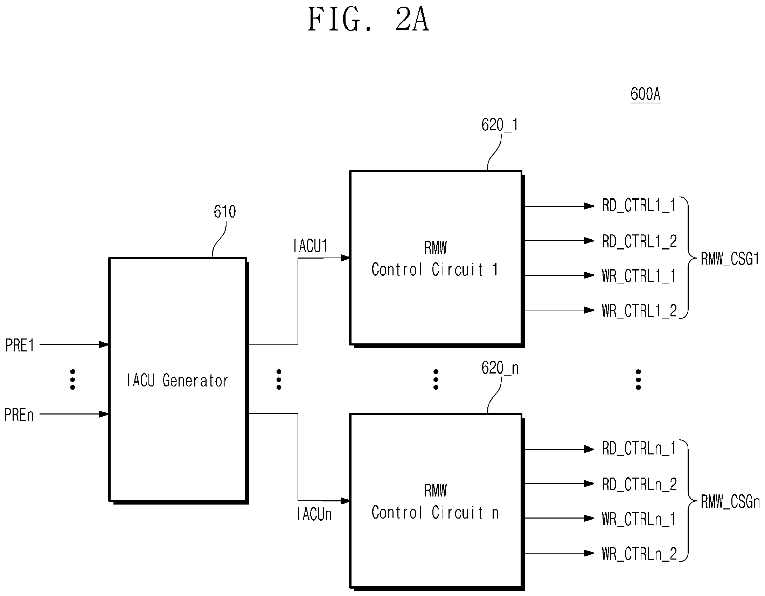

FIG. 2A is a block diagram illustrating an example of a RMW driver 600A. The RMW driver 600A of FIG. 2A may be the RMW driver 600 of FIG. 1.

Referring to FIG. 2A, the RMW driver 600A may include an internal active count update signal generator (hereinafter, referred to as an "IACU generator") 610 and a plurality of RMW control circuits 620_1 to 620_n.

The IACU generator 610 may receive a precharge command PRE and may generate an internal active count update signal (hereinafter, referred to as an "IACU signal") based on the received precharge command PRE.

The IACU generator 610 may continuously receive first to n-th precharge commands PRE1 to PREn corresponding to different banks. In this case, the IACU generator 610 may generate first to n-th internal active count update signals IACU1 to IACUn corresponding to the first to n-th precharge commands PRE1 to PREn in parallel. The first to n-th internal active count update signals IACU1 to IACUn may correspond to different banks, respectively.

Each of first to n-th RMW control circuits 620_1 to 620_n may be implemented to generate core signals for one bank.

As an example, the first RMW control circuit 620_1 may receive the first internal active count update signal IACU1 corresponding to a first bank and may generate core signals RD_CTRL1_1, RD_CTRL1_2, WR CTRL1 1, and WR_CTRL1_2 to control an RMW operation of the first bank.

Here, first_first and first_second read control signals RD_CTRL1_1 and RD_CTRL1_2 may be control signals to read out count data stored in a count cell of a target memory cell row included in the first bank. First_first and first_second write control signals WR_CTRL1_1 and WR_CTRL1_2 may be control signals to write the updated count data into the count cell again. The core signals RD_CTRL1_1, RD_CTRL1_2, WR_CTRL1_1, and WR_CTRL1_2 to control the RMW operation of the first bank may be referred to as a first RMW core signal group RMW_CSG1.

Similarly, the n-th RMW control circuit 620_n may receive the n-th internal active count update signal IACUn corresponding to the n-th bank and may generate an n-th RMW core signal group RMW_CSGn.

As described above, the RMW driver 600A according to the present implementation may generate a RMW core signal group RMW_CSG to perform the RMW operation for each bank. In particular, even when the precharge commands PREs corresponding to different banks are continuously received, the RMW driver 600A may generate the RMW core signal group RMW_CSG for each bank in parallel. Accordingly, the RMW operation for each bank may be performed effectively without degrading the performance.

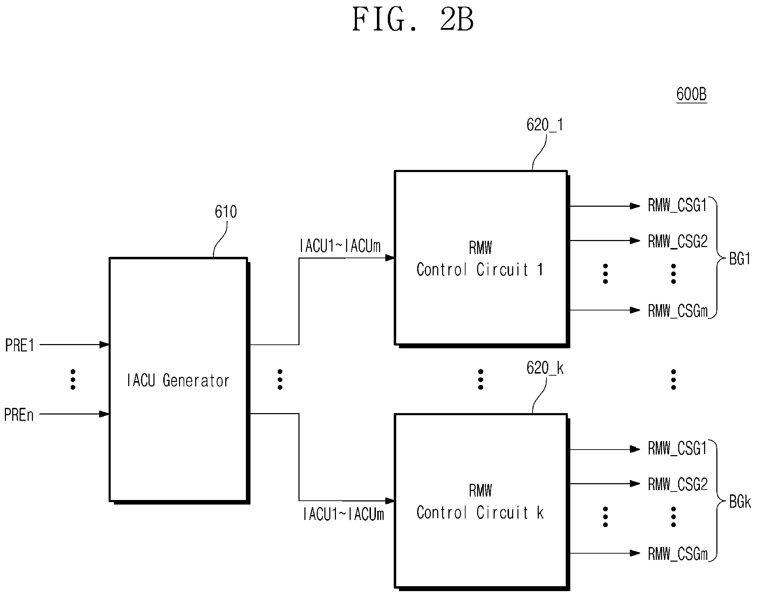

FIG. 2B is a block diagram illustrating an example of a RMW driver 600B. The RMW driver 600B of FIG. 2B may be the RMW driver 600 of FIG. 1. The RMW driver 600B of FIG. 2B is similar to the RMW driver 600A of FIG. 2A. In FIG. 2B, the same or similar reference numerals denote the same or similar elements in FIG. 2A, and thus, detailed descriptions of the same or similar elements will be omitted.

Different from the structure of the RMW driver 600A of FIG. 2A in which one RMW control circuit corresponds to one bank, the RMW driver 600B of FIG. 2B may have a structure in which one RMW control circuit corresponds to a plurality of banks.

Referring to FIG. 2B, each of RMW control circuits 620_1 to 620_k may correspond to one bank group BG, and the one bank group BG may include m banks ( `m' being a natural number equal to or greater than 2).

As an example, a first RMW control circuit 620_1 may correspond to a first bank group BG1, and the first bank group BG1 may include m banks. In this case, the first RMW control circuit 620_1 may receive internal active count update signals IACU1 to IACUm with respect to the m banks in parallel and may generate m RMW core signal groups RMW_CSG1 to RMW_CSGm respectively corresponding to the m banks.

Similarly, a k-th RMW control circuit 620_k may correspond to a k-th bank group BGk. The k-th RMW control circuit 620_k may receive internal active count update signals IACU1 to IACUm with respect to the m banks in parallel and may generate the m RMW core signal groups RMW_CSG1 to RMW_CSGm respectively corresponding to the m banks.

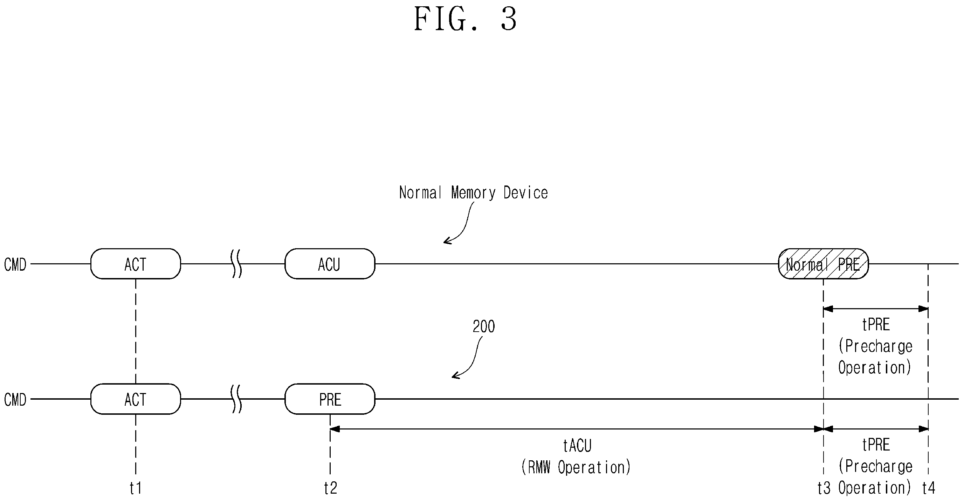

FIG. 3 is a view illustrating an example of a precharge command. For the convenience of explanation, it is assumed that both a normal memory device and the memory device 200 (refer to FIG. 1) according to the present disclosure receive an active command ACT at the same first time point t1. In addition, it is assumed that the normal memory device receives an active count update command ACU at a second time point t2.

Referring to FIG. 3, the normal memory device receives the active command ACT at the first time point t1. Then, the normal memory device receives the active count update command ACU at the second time point t2 and performs an RMW operation to update an active count. Then, the normal memory device receives a precharge command Normal PRE at a third time point t3, and thus, the normal memory device performs a precharge operation at the third time point t3 in response to the precharge command Normal PRE received.

On the other hand, the memory device 200 according to the present disclosure may receive the active command ACT at the first time point t1 and may receive the precharge command PRE at the second time point t2 earlier than the third time point t3. That is, the memory device 200 according to the present disclosure may receive the precharge command PRE at a time point earlier than the normal memory device by the active count update time tACU. In the present implementation, the active count update time tACU may be a predetermined time and may be the time required to perform the RMW operation for each bank.

In this case, the memory device 200 according to the present disclosure may perform the RMW operation for each bank based on the precharge command PRE received at the second time point t2. Then, the memory device 200 may perform the precharge operation at the third time point t3 elapsed by the active count update time tACU from the second time point t2. That is, the precharge operation may be performed with a delay by the active count update time tACU from the time point at which the precharge command PRE is received.

As described above, the memory device 200 according to the present disclosure may receive the precharge command PRE at a time point earlier than the normal memory device by the active count update time tACU according to a predetermine protocol. In addition, the memory device 200 according to the present disclosure may perform not only the precharge operation but also the RMW operation based on the precharge command PRE. In this case, there is no need to receive the separate dedicated command, which is required to perform the RMW operation, from the host, and thus consequently, the complexity of the protocol between the memory controller 100 and the memory device 200 may be improved.

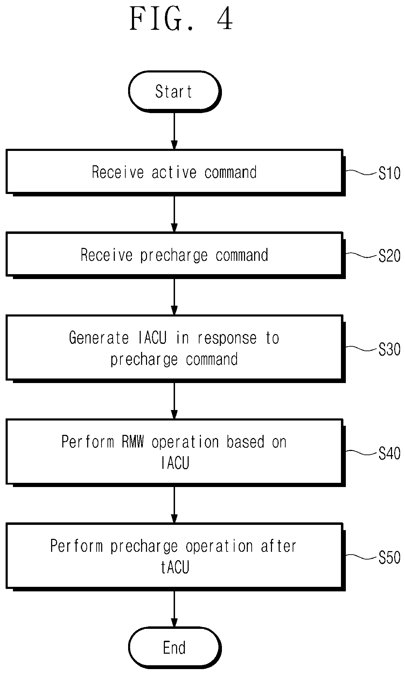

FIG. 4 is a flowchart illustrating an example of an operation of the memory device. The memory device described with reference to FIG. 4 may correspond to the memory device 200 of FIGS. 1 and 3.

In operation S10, the memory device 200 may receive the active command ACT. Accordingly, the word line corresponding to the target memory cell row may be activated. Then, a read operation or a write operation may be performed on the target memory cell row according to the implementations.

In operation S20, the memory device 200 may receive the precharge command PRE. The memory device 200 may receive the precharge command PRE at a time point earlier by the active count update time tACU than the normal memory device.

In operation S30, the memory device 200 may generate the internal active count update signal IACU based on the precharge command PRE. When the precharge commands PREs corresponding to different banks are continuously received, the memory device 200 may generate the internal active count update signals IACUs corresponding to the continuously received precharge commands PREs in parallel.

In operation S40, the memory device 200 may perform the RMW operation based on the internal active count update signal IACU. When the precharge commands PREs corresponding to different banks are continuously received, the memory device 200 may perform the RMW operations for different banks in parallel based on the internal active count update signals IACUs that are generated in parallel. That is, the RMW operations on different banks may be substantially simultaneously performed.

In operation S50, the memory device 200 may perform the precharge operation. In this case, the precharge operation may be performed at the time point elapsed by the active count update time tACU from the time point where the precharge command PRE is received. Accordingly, the word line corresponding to the target memory cell row may be deactivated.

As described above, the memory device 200 according to the present disclosure may perform the RMW operation based on the precharge command. In addition, even when the precharge commands for different banks are continuously received, the memory device 200 according to the present disclosure may perform the RMW operations for each bank in parallel. Accordingly, the RMW operation may be performed effectively without degrading the performance and increasing the complexity of the protocol between the memory controller 100 and the memory device 200.

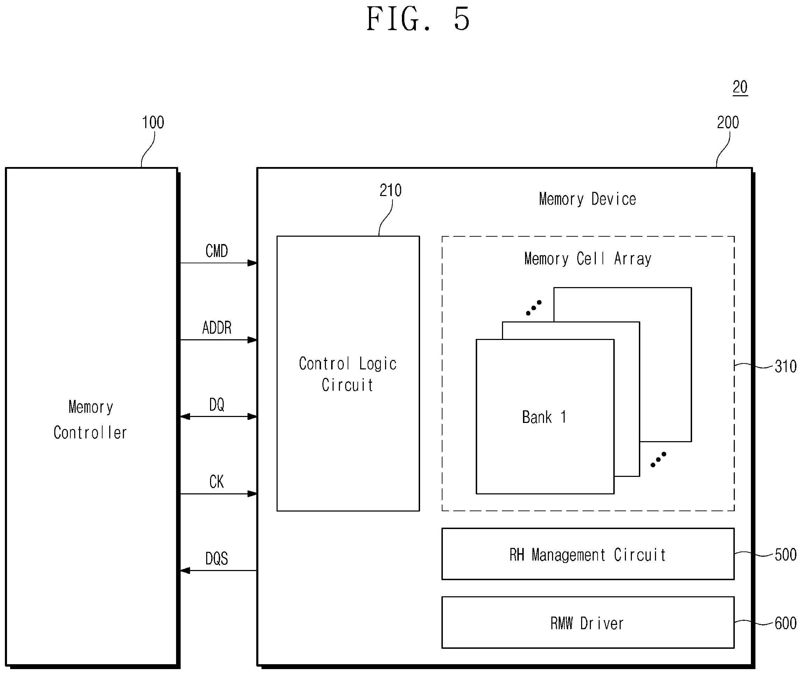

FIG. 5 is a block diagram illustrating an example of a memory system 20. The memory system 20 of FIG. 5 is similar to the memory system 10 of FIG. 1. In FIG. 5, the same or similar reference numerals denote the same or similar elements in FIG. 1, and thus, detailed descriptions of the same elements will be omitted.

Referring to FIG. 5, the memory system 20 may include a memory controller 100 and a memory device 200, and the memory device 200 may include a memory cell array 310, a row hammer management circuit 500, an RMW driver 600, and a control logic circuit 210.

The memory controller 100 may transmit a clock signal CK, a command CMD, and an address ADDR to the memory device 200. The memory controller 100 may receive a data strobe signal DQS from the memory device 200 when reading out a data signal DQ from the memory device 200.

The control logic circuit 210 of the memory device 200 may control an operation of the memory device 200. As an example, the control logic circuit 210may generate control signals to allow the memory device 200 to perform a write operation, a read operation, a normal refresh operation, and a hammer refresh operation.

Here, the hammer refresh operation may mean an operation to reduce the row hammer phenomenon that refreshes an adjacent memory cell row adjacent to an aggressor memory cell row that is intensively accessed. The normal refresh operation may mean an operation that sequentially refreshes the memory cell rows of the memory cell array.

As shown in FIG. 5, the control logic circuit 210 and the RMW driver 600 may be implemented independently as different circuits.

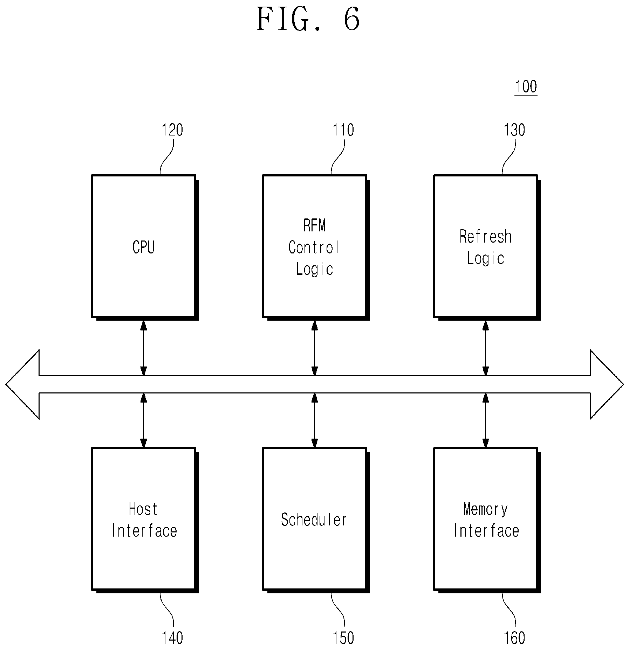

FIG. 6 is a block diagram illustrating an example of a configuration of a memory controller 100. The memory controller 100 of FIG. 6 may correspond to, for example, the memory controller 100 of FIG. 1 or 5.

Referring to FIG. 6, the memory controller 100 may include a CPU 120, an RFM control logic 110, a refresh logic 130, a host interface 140, a scheduler 150, and a memory interface 160, which are connected to each other through a bus.

The CPU 120 may control an overall operation of the memory controller 100. As an example, the CPU 120 may control each of the RFM control logic 110, the refresh logic 130, the host interface 140, the scheduler 150, and the memory interface 160.

The RFM control logic 110 may generate a refresh management (RFM) command with respect to a memory cell row related to the row hammer among the memory cell rows of the memory device 200. As an example, when it is determined that a specific memory cell row is intensively assessed, the RFM control logic 110 may generate a command to refresh an adjacent memory cell row adjacent to an aggressor memory cell row.

The refresh logic 130 may generate a command to perform the normal refresh operation on the memory cell rows of the memory device 200. As an example, the refresh logic 130 may generate an auto refresh command according to a refresh cycle to sequentially refresh the memory cell rows.

The host interface 140 may perform interfacing with the host. The memory interface 160 may perform interfacing with the memory device 200.

The scheduler 150 may manage scheduling and transmitting sequences of commands generated by the memory controller 100. In particular, the scheduler 150 according to the present implementation may transmit the precharge command PRE earlier than a transmission timing of the normal precharge command by the active count update time tACU. Accordingly, the precharge command PRE may be used as the command to perform not only the precharge operation but also the RMW operation.

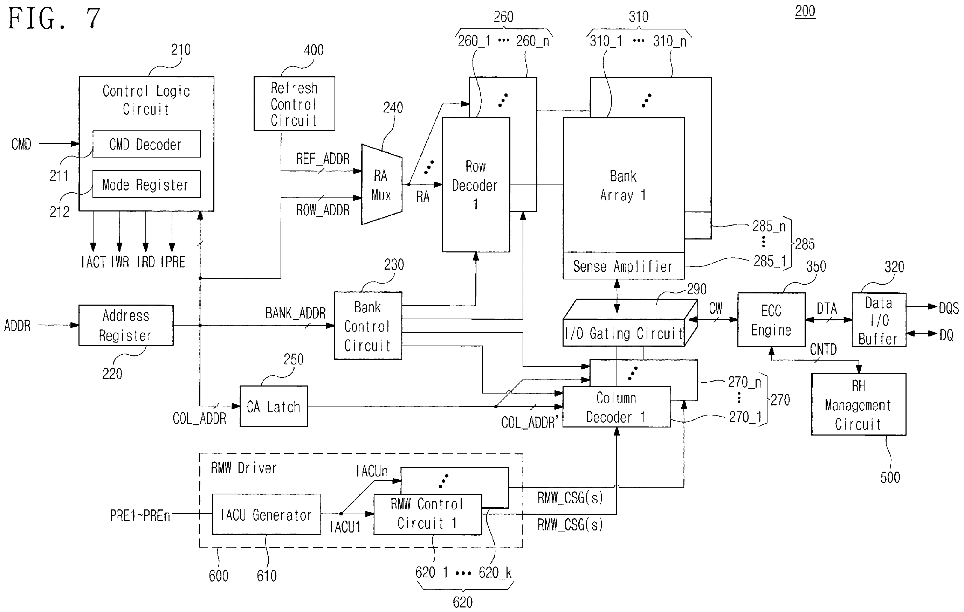

FIG. 7 is a block diagram illustrating an example of a memory device 200. The memory device 200 of FIG. 7 may correspond to the memory device 200 of FIGS. 1 and 5.

Referring to FIG. 7, the memory device 200 may include a control logic circuit 210, an address register 220, a bank control logic 230, a refresh control circuit 400, a row address multiplexer 240, a column address latch 250, a row decoder 260, a column decoder 270, a memory cell array 310, a sense amplifier part 285, an input/output (I/O) gating circuit 290, an ECC engine 350, a data I/O buffer 320, a row hammer management circuit 500, and an RMW driver 600.

The memory cell array 310 may include a plurality of bank arrays 310_1 to 310_n. Each of the bank arrays 310_1 to 310_n may include a plurality of memory cells. As an example, each of the memory cells may be formed at a point where a corresponding word line intersects a corresponding bit line.

The row decoder 260 may include a plurality of sub-row decoders 260_1 to 260_n. Each of the sub-row decoders 260_1 to 260_n may be connected to a corresponding bank array among the bank arrays 310_1 to 310_n.

The sense amplifier part 285 may include a plurality of sense amplifiers 285_1 to 285_n. Each of the sense amplifiers 285_1 to 285_n may be connected to a corresponding bank array among the bank arrays 310_1 to 310_n.

The column decoder 270 may include a plurality of sub-column decoders 270_1 to 270_n. Each of the sub-column decoders 270_1 to 270_n may be connected to a corresponding bank array among the bank arrays 310_1 to 310_n via a corresponding sense amplifier among the sense amplifiers 285_1 to 285_n.

The bank arrays 310_1 to 310_n, the sense amplifiers 285_1 to 285_n, the column decoders 270_1 to 270_n, and the row decoders 260_1 to 260_n may form the plural banks. As an example, a first bank array 310_1, a first sense amplifier 285_1, a first column decoder 270_1, and a first row decoder 260_1 may form a first bank.

The address register 220 may receive an address ADDR including a bank address BANK_ADDR, a row address ROW_ADDR, and a column address COL_ADDR from the memory controller 100 (refer to FIG. 1). The address register 220 may provide the received bank address BANK_ADDR to the bank control logic 230, may provide the received row address ROW_ADDR to the row address multiplexer 240, and may provide the received column address COL_ADDR to the column address latch 250. In addition, the address register 220 may provide the bank address BANK_ADDR and the row address ROW_ADDR to the row hammer management circuit 500 and the RMW driver 600.

The bank control logic 230 may generate bank control signals in response to the bank address BANK_ADDR. As an example, a row decoder corresponding to the bank address BANK_ADDR among the row decoders 260_1 to 260_n may be activated in response to the bank control signals. A column decoder corresponding to the bank address BANK_ADDR among the column decoders 270_1 to 270_n may be activated in response to the bank control signals.

The row address multiplexer 240 may receive the row address ROW_ADDR from the address register 220 and may receive a refresh row address REF_ADDR from the refresh control circuit 400. The row address multiplexer 240 may selectively output the row address ROW_ADDR or the refresh row address REF_ADDR as a row address RA. The row address RA output from the row address multiplexer 240 may be applied to each of the row decoders 260_1 to 260_n.

The refresh control circuit 400 may sequentially increase or decrease the refresh row address REF_ADDR in a normal refresh mode in response to refresh signals from the control logic circuit 210.

The refresh control circuit 400 may receive a hammer address HADDR in a hammer refresh mode. The refresh control circuit 400 may output an address of adjacent memory cell rows adjacent to an aggressor memory cell row as the refresh row address REF_ADDR based on the hammer address HADDR.

A row decoder selected by the bank control logic 230 among the row decoders 260_1 to 260_n may activate a word line corresponding to the row address RA output from the row address multiplexer 240. As an example, the selected row decoder may apply a word line driving voltage to the word line corresponding to the row address.

The column address latch 250 may receive the column address COL_ADDR from the address register 220 and may temporarily store the received column address COL_ADDR. In addition, for example, in a burst mode, the column address latch 250 may gradually increase the received column address COL_ADDR. The column address latch 250 may apply a column address COL_ADDR' obtained by temporarily storing or gradually increasing the column address COL_ADDR to each of the column decoders 270_1 to 270_n.

The column decoder activated by the bank control logic 230 among the column decoders 270_1 to 270_n may activate the sense amplifier corresponding to the bank address BANK_ADDR and the column address COL _ADDR through the I/O gating circuit 290.

The I/O gating circuit 290 may include circuits to perform gating input and output data. In addition, the I/O gating circuit 290 may include data latches to store code words output from the bank arrays 310_1 to 310_n and write drivers to write data in the bank arrays 310_1 to 310_n.

In some implementations, a code word CW read out from the selected bank array among the bank arrays 310_1 to 310_n during the read operation may be sensed by the sense amplifier corresponding to the selected bank array and may be stored in the data latches of the I/O gating circuit 290. In addition, the code word CW stored in the data latches may be ECC decoded by the ECC engine 350 and may be provided to the data I/O buffer 320 as data DTA. The data I/O buffer 320 may generate the data signal DQ based on the data DTA and may provide the data signal DQ together with the data strobe signal DQS to the memory controller 100.

In some implementations, during the write operation, data DTA to be written in the selected bank array among the bank arrays 310_1 to 310_n may be received as the data signal DQ by the data I/O buffer 320. The data I/O buffer 320 may convert the data signal DQ into the data DTA and may provide the data DTA to the ECC engine 350. The ECC engine 350 may generate parity bits or parity data based on the data DTA and may provide the code word CW including the data DTA and the parity bits to the I/O gating circuit 290. The I/O gating circuit 290 may write the code word CW in the selected bank array.

The data I/O buffer 320 may convert the data signal DQ into the data DTA during the write operation and may provide the data DTA to the ECC engine 350. The data I/O buffer 320 may convert the data DTA provided from the ECC engine 350 into the data signal DQ during the read operation.

The ECC engine 350 may perform an ECC encoding operation on the data DTA during the write operation. The ECC engine 350 may perform an ECC decoding operation on the code word CW during the read operation.

In addition, the ECC engine 350 may perform ECC encoding and ECC decoding operations on count data CNTD provided from the row hammer management circuit 500.

The control logic circuit 210 may control an operation of the memory device 200. As an example, the control logic circuit 210 may generate the control signals to allow the memory device 200 to perform the write operation, the read operation, the normal refresh operation, and the hammer refresh operation. The control logic circuit 210 may include a command decoder 211 that decodes a command CMD provided from the memory controller 100 and a mode register set (MRS) 212 that sets an operation mode of the memory device 200.

The command decoder 211 may decode the command CMD to generate internal command signals such as an internal active signal IACT, an internal precharge signal IPRE, an internal read signal IRD, an internal write signal IWR, etc. In addition, the command decoder 211 may decode a chip select signal and command/address signals to generate control signals corresponding to the command CMD.

In some implementations, when the internal precharge signal IPRE is generated, the command decoder 211 may delay the precharge command PRE received from the memory controller 100 by a predetermine time. That is, the command decoder 211 may generate the internal precharge signal IPRE after the predetermined time elapses from a time point at which the command decoder 211 receives the precharge command PRE from the memory controller 100. Here, the predetermined time may correspond to the active count update time tACU. Accordingly, the word line activated by the active command ACT may be maintained in the activated state during the RMW operation.

The RMW driver 600 may receive the precharge command PRE from the memory controller 100. The RMW driver 600 may generate the RMW core signal group RMW_CSG to perform the RMW operation on each bank. The RMW driver 600 may include the IACU generator 610 and the RMW control circuits 620_1 to 620_n.

The IACU generator 610 may continuously receive the first to n-th precharge commands PRE1 to PREn corresponding to different banks. In this case, the IACU generator 610 may generate the first to n-th internal active count update signals IACU1 to IACUn corresponding to the first to n-th precharge commands PRE1 to PREn in parallel.

As described with reference to FIG. 2A, each of the first to k-th RMW control circuits 620_1 to 620_k may be implemented to generate the core signals for one bank. As an example, the first RMW control circuit 620_1 may receive the first internal active count update signal IACU1 corresponding to the first bank and may be referred to as a first RMW core signal group RMW_CSG1 to control an RMW operation of the first bank.

As described with reference to FIG. 2B, each of the first to k-th RMW control circuits 620_1 to 620_k may correspond to the one bank group BG, and the one bank group BG may include the m banks. As an example, the first RMW control circuit 620_1 may receive the internal active count update signals IACU1 to IACUm with respect to the m banks in parallel and may generate the m RMW core signal groups RMW_CSG1 to RMW_CSGm corresponding to the m banks in parallel.

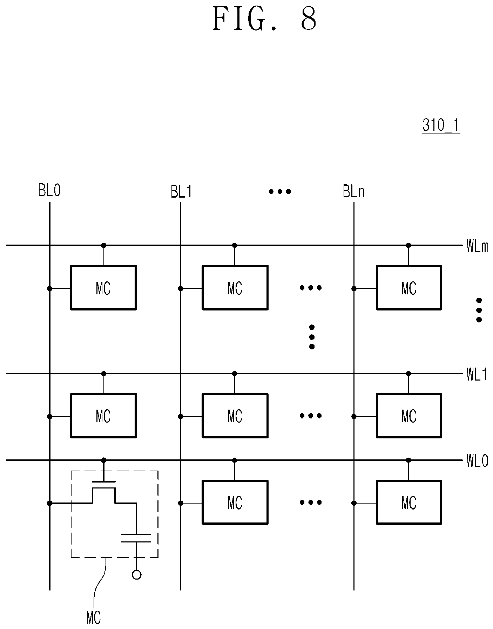

FIG. 8 is a view illustrating an example of a bank array 310_1. The bank array 310_1 of FIG. 8 may correspond to, for example, the first bank array 310_1 of FIG. 7.

Referring to FIG. 8, the first bank array 310_1 may include a plurality of word lines WL0 to WLm, a plurality of bit lines BL0 to BLn, and a plurality of memory cells MCs located at points where the word lines WL0 to WLm intersect the bit lines BL0 to BLn.

Each memory cell MC may be a DRAM cell. As an example, each of the memory cells MCs may include a cell transistor connected to the word line and the bit line and a cell capacitor connected to the cell transistor.

The word lines extending in a row direction may be referred to a row of the first bank array 310_1. The bit lines extending in a column direction may be referred to as a column of the first bank array 310_1.

In the present disclosure, the memory cells connected to the same word lines may be referred to as the memory cell row. In the case where the specific memory cell row is intensively accessed, the memory cell row that is intensively accessed may be referred to as the aggressor memory cell row. The memory cell row adjacent to the aggressor memory cell row may be referred to as the adjacent memory cell row. As an example, when the access is concentrated on the first word line, the first memory cell row corresponding to the first word line may be referred as the aggressor memory cell row, and zero-th and second memory cell rows adjacent to the first memory cell row may be referred to as the adjacent memory cell row.

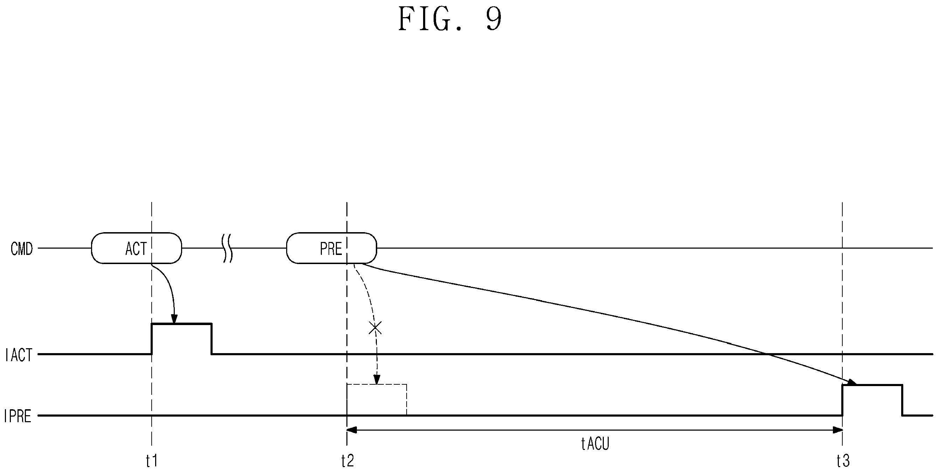

FIG. 9 is a diagram illustrating an example of an operation of generating the inner precharge signal IPRE.

Referring to FIG. 9, the memory device 200 (refer to FIG. 5) may receive the active command ACT from the memory controller 100 (refer to FIG. 5). In this case, the control logic circuit 210 (refer to FIG. 7) of the memory device 200 may generate the internal active signal IACT based on the active command ACT at the first time point t1. The selected word line may be activated in response to the internal active signal IACT.

Then, the memory device 200 may receive the precharge command PRE from the memory controller 100. The control logic circuit 210 may generate the internal precharge signal IPRE based on the received precharge command PRE. In this case, the control logic circuit 210 may generate the internal precharge signal IPRE at the third time point t3 elapsed by the active count update time tACU from the second time point t2 at which the precharge command PRE is received. That is, the control logic circuit 210 may delay the precharge operation by the active count update time tACU. Accordingly, the active count update time tACU required to perform the RMW operation on the memory cell row corresponding to the selected word line may be secured.

After the RMW operation on the memory cell row corresponding to the selected word line is performed, the control logic circuit 210 may generate the internal precharge signal IPRE at the third time point t3, and thus, the selected word line may be precharged.

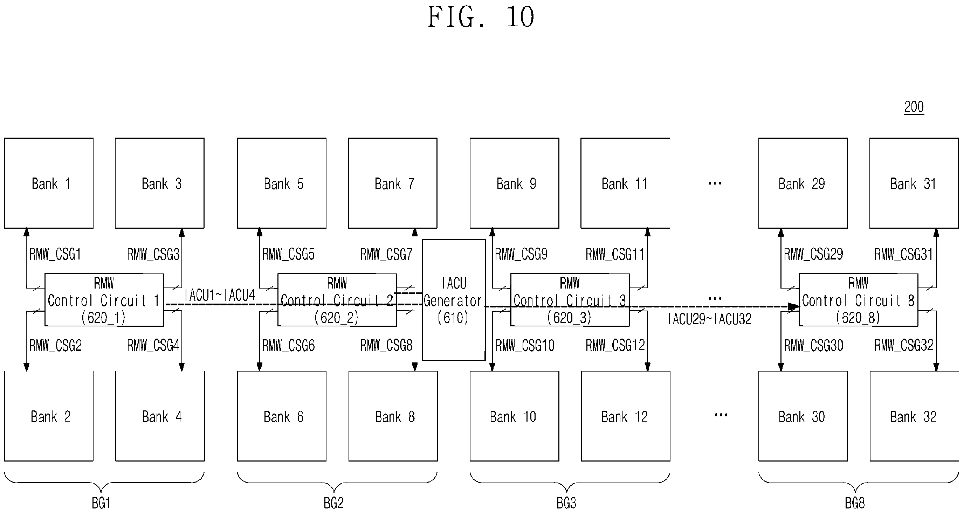

FIG. 10 is a view illustrating an example of an arrangement of the memory device 200. The memory device 200 of FIG. 10 may correspond to, for example, the memory device of FIGS. 1, 5, and 7. For the convenience of explanation, it is assumed that the memory device 200 includes thirty-two banks Bank 1 to Bank 32 and four banks form one bank group BG. In addition, it is assumed that one RMW control circuit corresponds to one bank group.

Referring to FIG. 10, the RMW driver 600 may include the IACU generator 610 and the first to eighth RMW control circuits 620_1 to 620_8.

First to fourth banks Bank 1 to Bank 4 may form the first bank group BG1. As an example, the first and third banks Bank 1 and Bank 3 may be disposed at an upper portion of a substrate, and the second and fourth banks Bank 2 and Bank 4 may be disposed at a lower portion of the substrate. The first RMW control circuit 620_1 may correspond to the first bank group BG1 and may be disposed adjacent to the first bank group BG1. As an example, the first RMW control circuit 620_1 may be disposed at a center between the first and third banks Bank1 and Bank 3 and the second and fourth banks Bank 2 and Bank 4.

Similarly, fifth to eighth banks Bank 5 to Bank 8 may form a second bank group BG2, and a second RMW control circuit 620_2 may be disposed adjacent to the second bank group BG2. Similarly, twenty-ninth to thirty-second banks Bank 29 to Bank 32 may form an eighth bank group BG8, and an eighth RMW control circuit 620_8 may be disposed adjacent to the eighth bank group BG8.

An area where the IACU generator 610 and the first to eighth RMW control circuits 620_1 to 620_8 are disposed may correspond to a peripheral area PERI of the substrate.

The IACU generator 610 may generate the internal active count update signal IACU for each bank. As an example, the IACU generator 610 may receive a first precharge command PRE1 for the first bank Bank 1 and may generate the first internal active count update signal IACU1 corresponding to the first bank Bank 1. When the precharge commands for the banks are continuously received, the IACU generator 610 may generate the internal active count update signals IACUs corresponding to each bank.

Each of the first to eighth RMW control circuits 620_1 to 620_8 may receive at least one internal active count update signal IACU for a corresponding bank group from the IACU generator 610. Each of the first to eighth bank groups BG1 to BG8 may generate the RMW core signal group RMW_CSG for each bank based on the received internal active count update signal IACU.

As an example, the first RMW control circuit 620_1 may receive at least one of the first to fourth internal active count update signals IACU1 to IACU4. The first RMW control circuit 620_1 may generate the RMW control signal group RMW_CSG for the corresponding bank based on the received at least one internal active count update signal.

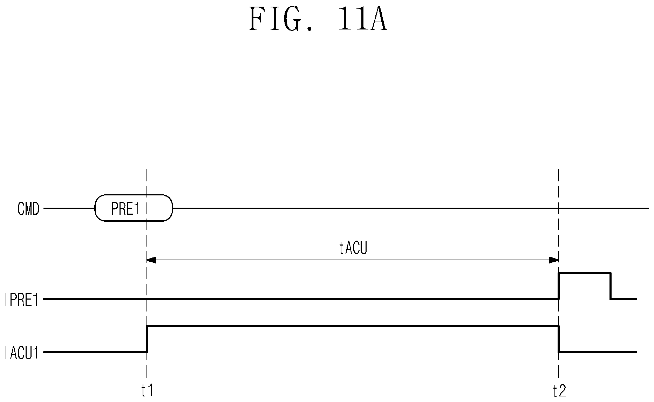

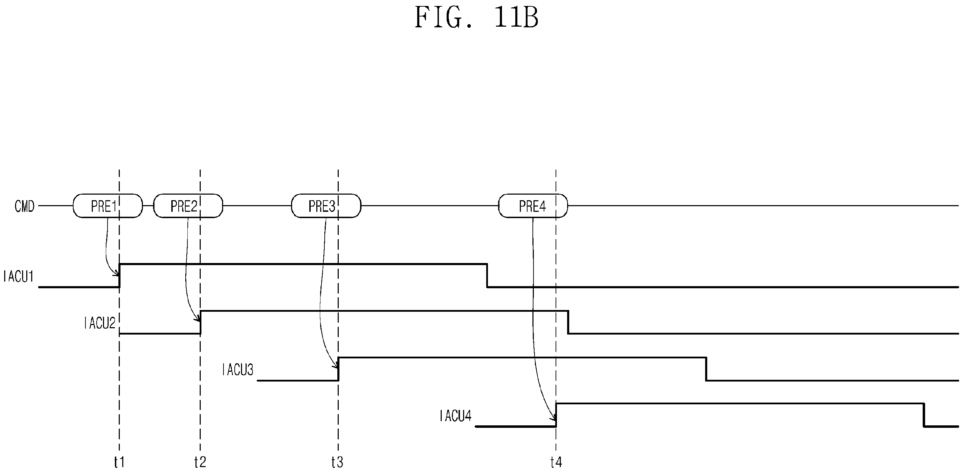

FIGS. 11A and 11B are diagrams illustrating an example of an operation of the IACU generator of the RMW driver. In detail, FIG. 11A illustrates an operation in which the IACU generator generates one internal active count update signal IACU based on one precharge command PRE. FIG. 11B illustrates an operation in which the IACU generator generates plural internal active count update signals IACUs in parallel based on plural precharge commands PREs continuously received. For the convenience of explanation, in the following descriptions with reference to FIGS. 11A and 11B, it is assumed that the IACU generator and the memory device are arranged as in FIG. 10.

Referring to FIGS. 10 and 11A, the memory device 200 may receive the first precharge command PRE1 for the first bank Bank 1 at the first time point t1. In this case, the IACU generator 610 may transition a level of the first internal active count update signal IACU1 from a low level to a high level based on the first precharge command PRE1.

Then, when the active count update time tACU is elapsed, the control logic circuit 210 may generate a first internal precharge signal IPRE1 at the second time point t2. In this case, the IACU generator 610 may transition the level of the first internal active count update signal IACU1 from the high level to the low level at the second time point t2 based on the first internal precharge signal IPRE1.

Consequently, the first internal active count update signal IACU1 may be maintained in the high state during the active count update time tACU.

Referring to FIGS. 10 and 11B, the memory device 200 may continuously receive the first to fourth precharge commands PRE1 to PRE4 for the first to fourth banks Bank 1 to Bank 4 of the first bank group BG1. In this case, a time interval between the precharge commands may be very short according to some implementations.

The IACU generator 610 may transition the level of the first to fourth internal active count update signals IACU1 to IACU4 from the low level to the high level based on the first to fourth precharge commands PRE1 to PRE4 that are continuously received.

As an example, the IACU generator 610 may transition the level of the first to fourth internal active count update signals IACU1 to IACU4 from the low level to the high level at the first to fourth time points t1 to t4, respectively. In this case, each of the first to fourth internal active count update signals IACU1 to IACU4 may maintain the high level during the active count update time tACU.

Consequently, in the case where the first to fourth precharge commands PRE1 to PRE4 for the first to fourth banks Bank 1 to Bank 4 are continuously received, the IACU generator 610 may generate the first to fourth internal active count update signals IACU1 to IACU4 with respect to the first to fourth banks Bank 1 to Bank 4 in parallel. In this case, sections in which the first to fourth internal active count update signals IACU1 to IACU4 maintain the high level, respectively, may overlap with each other.

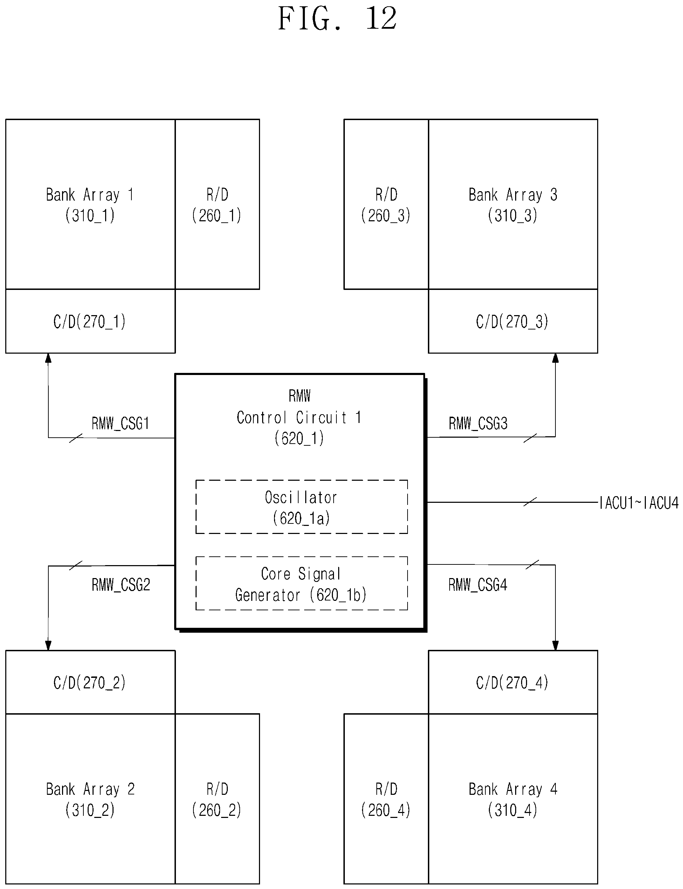

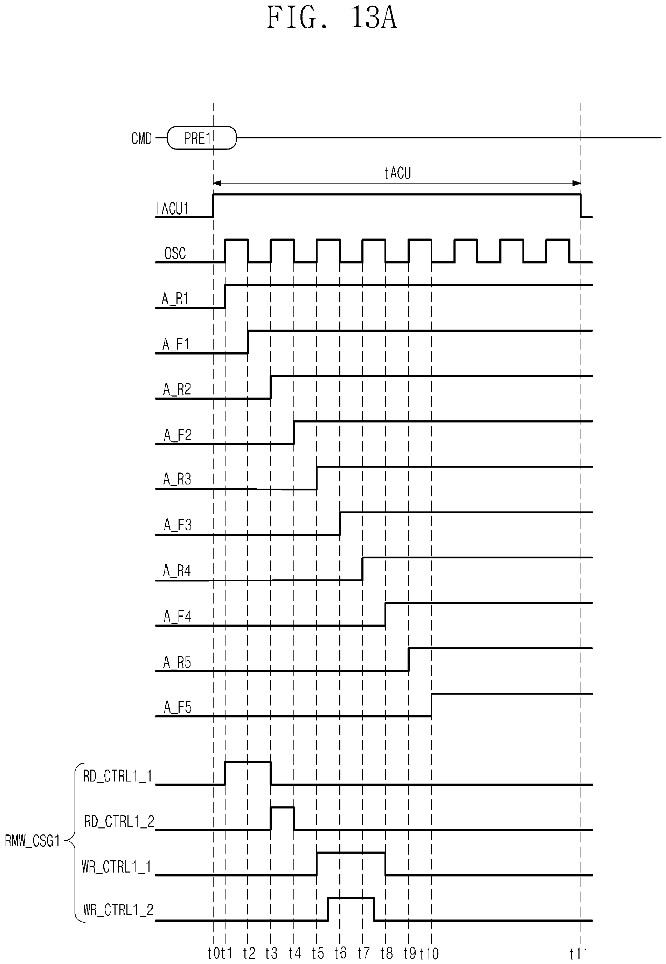

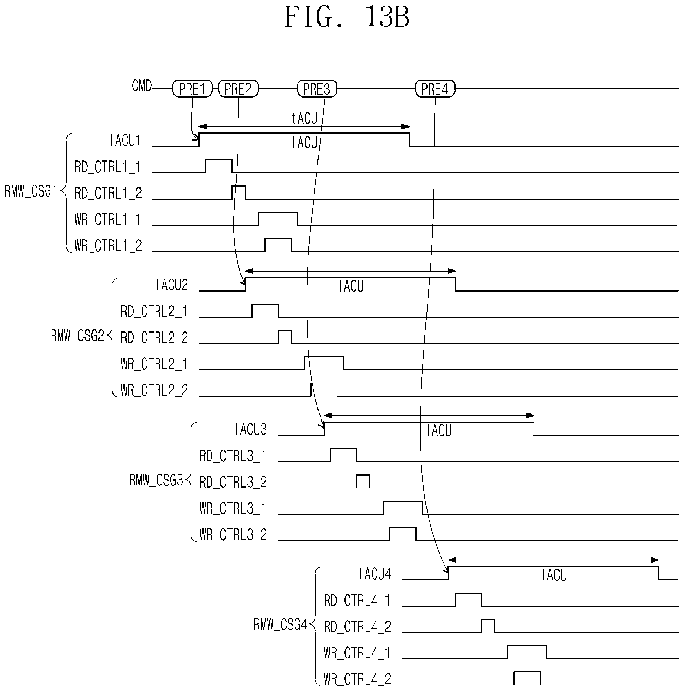

FIGS. 12, 13A, and 13B are diagrams illustrating an example of a configuration and operation of the RMW control circuit of the RMW driver. In detail, FIG. 12 shows the configuration of the first RMW control circuit 620_1 according to an implementation of the present disclosure. FIG. 13A shows an operation in which the first RMW control circuit 620_1 generates one RMW core signal group RMW_CSG based on one internal active count update signal IACU. FIG. 13B shows an operation in which the first RMW control circuit 620_1 generates the first to fourth RMW core signal groups RMW_CSG1 to RMW_CSG4 based on the first to fourth internal active count update signals IACU1 to IACU4.

For the convenience of explanation, it is assumed that the RMW control circuit and the memory device of FIGS. 12, 13A, and 13B are arranged as in FIG. 10. In addition, it is assumed that the internal active count update signal IACU is generated as in FIG. 11.

Referring to FIG. 12, the first bank group BG1 may include the first, second, third, and fourth bank arrays 310_1, 310_2, 310_3, and 310_4, the first, second, third, and fourth row decoders 260_1, 260_2, 260_3, and 260_4, the first, second, third, and fourth column decoders 270_1, 270_2, 270_3, and 270_4, and the first RMW control circuit 620_1.

The first row decoder 260_1 and the first column decoder 270_1 may be disposed adjacent to the first bank array 310_1. The second row decoder 260_2 and the second column decoder 270_2 may be disposed adjacent to the second bank array 310_2. The third row decoder 260_3 and the third column decoder 270_3 may be disposed adjacent to the third bank array 310_3. The fourth row decoder 260_4 and the fourth column decoder 270_4 may be disposed adjacent to the fourth bank array 310_4. The first RMW control circuit 620_1 may be disposed between the first to fourth bank arrays 310_1 to 310_4.

Areas in which the first to fourth bank arrays 310_1 to 310_4 are disposed may correspond to a core area of the substrate. Areas in which the first to fourth row decoders 260_1 to 260_4, the first to fourth column decoders 270_1 to 270_4, and the first RMW control circuit 620_1 are disposed may correspond to the peripheral area of the substrate.

The first RMW control circuit 620_1 may include an oscillator 620_1a and a core signal generator 620_1b.

The oscillator 620_1a may generate an oscillation signal OSC in response to the internal active count update signal IACU. As an example, the oscillator 620_1a may generate the oscillation signal OSC having a predetermined frequency in a section where the internal active count update signal IACU is at the high level. The frequency of the oscillation signal OSC may be set in various ways or variable depending on an operation frequency of the memory device 200.

The core signal generator 620_1b may generate the RMW core signal group RMW_CSG for each bank based on the internal active count update signal IACU and the oscillation signal OSC.

Referring to FIGS. 12 and 13A, the first RMW control circuit 620_1 may receive the first internal active count update signal IACU1 from the IACU generator 610 at a zero-th time point t0. The first RMW control circuit 620_1 may generate the oscillation signal OSC based on the first internal active count update signal IACU1. The oscillation signal OSC may be generated in the section where the first internal active count update signal IACU1 is at the high level.

The core signal generator 620_1b may generate a plurality of intermediate signals A_R1 to A_R5 and A_F1 to A_F5 in synchronization with a rising edge or a falling edge of the oscillation signal OSC.

As an example, the core signal generator 620_1b may generate a first rising intermediate signal A_R1 in synchronization with the rising edge of the oscillation signal OSC at the first time point t1. The core signal generator 620_1b may generate a first falling intermediate signal A_F1 in synchronization with the falling edge of the oscillation signal OSC at the second time point t2. The core signal generator 620_1b may generate a second rising intermediate signal A_R2 in synchronization with the rising edge of the oscillation signal OSC at the third time point t3. The core signal generator 620_1b may generate a second falling intermediate signal A_F2 in synchronization with the falling edge of the oscillation signal OSC at the fourth time point t4. In this way, the core signal generator 620_1b may generate the first to fifth rising intermediate signals A_R1 to A_R5 and the first to fifth falling intermediate signals A_F1 to A_F5 at the first to tenth time points t1 to t10.

In addition, the core signal generator 620_1b may generate the read control signals RD_CTRL1_1 and RD_CTRL_1_2 and the write control signals WR_CTRL1_1 and WR_CTRL_1_2, which are to be applied to the first bank array 310_1, the first row decoder 260_1, and the first column decoder 270_1, based on the intermediate signals A_R1 to A_R5 and A_F1 to A_F5.

As an example, the core signal generator 620_1b may generate the first_first read control signal RD_CTRL1_1 based on the first rising intermediate signal A_R1 and the second rising intermediate signal A_R2. The core signal generator 620_1b may generate the first_second read control signal RD_CTRL1_2 based on the second rising intermediate signal A_R2 and the second falling intermediate signal A_F2. The core signal generator 620_1b may generate the first_first write control signal WR_CTRL1_1 based on a third rising intermediate signal A_R3 and a fourth falling intermediate signal A_F4. The core signal generator 620_1b may generate the first_second write control signal WR_CTRL_1_2 based on the third rising intermediate signal A_R3 and the fourth rising intermediate signal A_R4.

However, this is merely an example, and the read control signals RD_CTRL1_1 and RD_CTRL_1_2 and the write control signals WR_CTRL1_1 and WR_CTRL_1_2 may be generated in a variety ways, for example, may be generated based on other intermediate signals.

The read control signals RD_CTRL1_1 and RD_CTRL_1_2 and the write control signals WR CTRL1_1 and WR_CTRL_1_2 generated by the core signal generator 620_1b may constitute the first RMW core signal group RMW_CSG1 and may be used as the control signals to control the RMW operation for the first bank Bank 1.

As described above, in the case where one internal active count update signal IACU is received, the first RMW control circuit 620_1 may generate the RMW core signal group RMW_CSG based on the received internal active count update signal IACU.

Meanwhile, as described with reference to FIGS. 10 and 11B, the RMW driver 600 may receive the first to fourth precharge commands PRE1 to PRE4. Based on the received first to fourth precharge commands PRE1 to PRE4, the IACU generator 610 of the RMW driver 600 may generate the first to fourth internal active count update signals IACU1 to IACU4 in parallel.

In this case, referring to FIGS. 12 and 13B, the first RMW control circuit 620_1 may sequentially receive the first to fourth internal active count update signals IACU1 to IACU4. Based on the received first to fourth internal active count update signals IACU1 to IACU4, the first RMW control circuit 620_1 may generate the first to fourth RMW core signal groups RMW_CSG1 to RMW_CSG4 in parallel.

As an example, the first RMW control circuit 620_1 may generate the first RMW core signal group RMW_CSG1 based on the first internal active count update signal IACU1. The first RMW control circuit 620_1 may generate the second RMW core signal group RMW_CSG2 based on the second internal active count update signal IACU2. In the same way, the first RMW control circuit 620_1 may generate the third RMW core signal group RMW_CSG3 based on the third internal active count update signal IACU3 and may generate the fourth RMW core signal group RMW_CSG4 based on the fourth internal active count update signal IACU4.

In this case, at least some of the first to fourth RMW core signal groups RMW_CSG1 to RMW_CSG4 may overlap with each other within the same time period. In other words, at least some of the RMW operations for the first to fourth banks Bank 1 to Bank 4 may be substantially simultaneously performed.

As described above, even when the precharge commands PRE1 to PRE4 for different banks are received continuously at short time intervals, the RMW driver 600 according to the implementations of the present disclosure may generate the RMW control signal groups RMW_CSG1 to RMW_CSG4 for each bank in parallel. Consequently, the RMW operation for each bank may be substantially simultaneously performed, and thus, the RMW operation may be performed without degrading the performance.

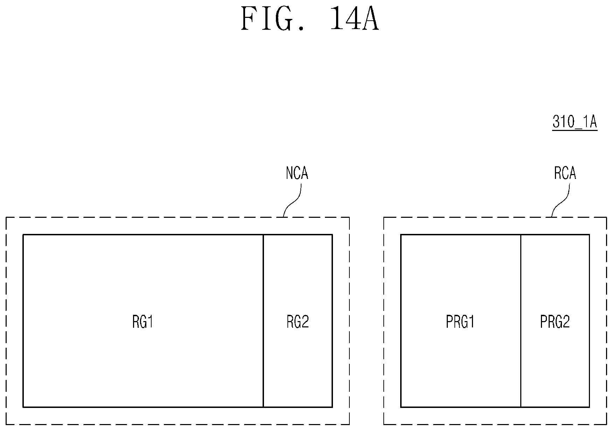

FIG. 14A is a view illustrating an example of a bank array 310_1A. The bank array 310_1A of FIG. 14A may correspond to, for example, one of the first bank arrays of FIGS. 1, 5, 7, and 12.

Referring to FIG. 14A, the bank array 310_1A may include a normal cell area NCA and a redundancy cell area RCA.

The normal cell area NCA may include a first region RG1 in which normal data is stored and a second region RG2 in which count data is stored. The redundancy cell area RCA may include a first region PRG1 in which parity data is stored and a second region PRG2 in which count parity data is stored. The parity data may be generated based on the normal data and may be used for the ECC encoding or decoding operation for the normal data. The count parity data may be generated based on the count data and may be used for the ECC encoding or decoding operation for the count data.

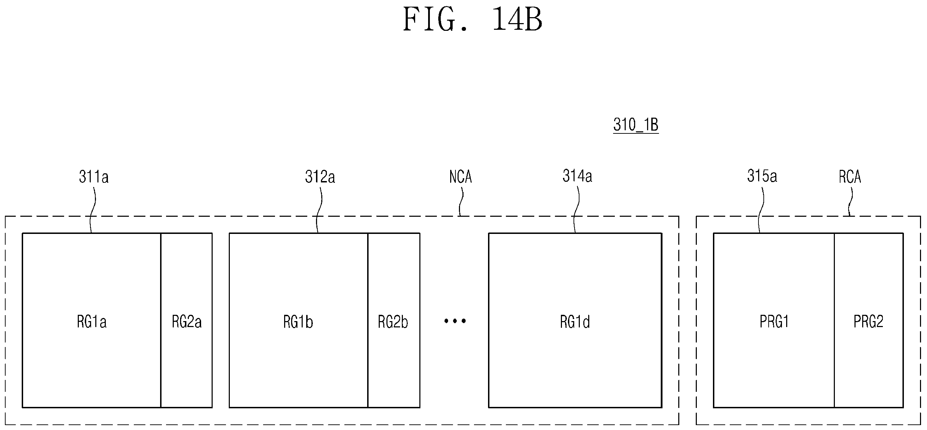

FIG. 14B is a view illustrating an example of a bank array 310_1B. The bank array 310_1B of FIG. 14B may correspond to, for example, one of the first bank arrays of FIGS. 1, 5, and 12.

Referring to FIG. 14B, the bank array 310_1B may include a plurality of sub-array blocks 311a to 315a. As an example, some 311a to 314a of the sub-array blocks 311a to 315a may form a normal cell area NCA, and the other 315a of the sub-array blocks 311a to 315a may form a redundancy cell area RCA.

At least some of the sub-array blocks 31 1a to 314a forming the normal cell area NCA may include a first region RG1 in which the normal data is stored and a second region RG2 in which the count data is stored. As an example, the first sub-array block 311a may include a first region RG1a in which the normal data is stored and a second region RG2a in which the count data is stored. The second sub-array block 312a may include a first region RG1b in which the normal data is stored and a second region RG2b in which the count data is stored. Meanwhile, in some implementations, the fourth sub-array block 314a may be implemented to include only a first region RG1d in which the normal data is stored.

The sub-array block 315a forming the redundancy cell area RCA may include a first region PRG1 in which parity data is stored and a second region PRG2 in which count parity data is stored.

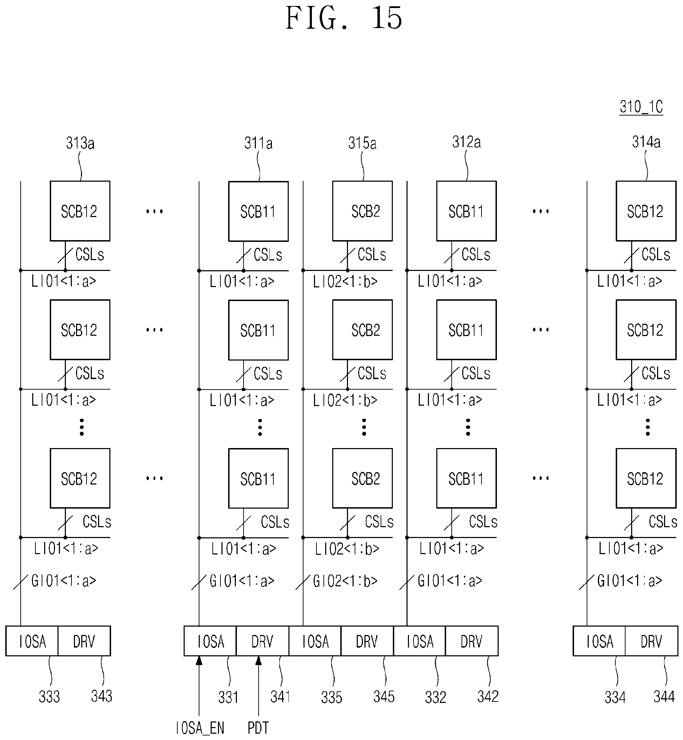

FIG. 15 is a view illustrating an example of a bank array 310_C. The bank array 310_1C of FIG. 15 may correspond to, for example, one of the first bank arrays of FIGS. 1, 5, 7, and 12.

Referring to FIG. 15, the bank array 310_1C may include first sub-array blocks SCB11, 311a, and 312a, second sub-array blocks SCB12, 313a, and 314a, a third sub-array block SCB2 and 315a, input/output sense amplifiers 331 to 335, and drivers 341 to 345.

A data input/output with respect to each of the first sub-array blocks 311a and 312a and the second sub-array blocks 313a and 314a may be performed through first global input/output lines GIO1<1:a> (a being a natural number) and first local input/output lines LIO I < 1: a>. Responsive to a read command or a write command, the bit lines may be selected by a column selection signal transmitted through column selection lines CSLs in each of the first sub-array blocks 311a and 312a and the second sub-array blocks 313a and 314a.

The number of the first sub-array blocks 311a and 312a and the second sub-array blocks 313a and 314a arranged in the column direction may be determined in various ways according to a size of data bits processed by the memory device 200.

A data input/output with respect to the third sub-array blocks SCB2 and 315a may be performed through second global input/output lines GIO2<1:b> (b being a natural number smaller than the a) and second local input/output lines LIO2<1:b>. Responsive to a read command or a write command, bit lines may be selected by a column selection signal transmitted through the column selection lines CSLs in each third sub-array block 315a. The number of the third sub-array blocks 315a should not be limited to that shown in FIG. 15.

Similar to those described with reference to FIG. 14B, the first sub-array blocks 311a and 312a may store the normal data and the count data, the second sub-array blocks 313a and 314a may store the normal data, and the third sub-array block may store the parity data and the count parity data.

The input/output sense amplifiers 331 to 334 may correspond to the first and second sub-array blocks 311a, 312a, 313a, and 314a. Each of the input/output sense amplifiers 331 to 334 may sense and amplify voltages output through the first global input/output lines GIO1<1:a>.

The input/output sense amplifier 335 may correspond to the third sub-array block 315a. The input/output sense amplifier 335 may sense and amplify voltages of the second global input/output lines GIO2<1:b> according to bits output through the second global input/output lines GIO2<1:b>.

The drivers 341 to 344 may correspond to the first and second sub-array blocks 311a, 312a, 313a, and 314a. The drivers 341 to 344 may transmit data to memory cells of the first and second sub-array blocks 311a, 312a, 313a, and 314a through the first global input/output lines GIO1<1:a> and the first local input/output lines LIO1<1:a>.

The driver 345 may correspond to the third sub-array block 315a. The driver 345 may transmit data to memory cells of the third sub-array block 315a through the second global input/output lines GIO2<1:b> and the second local input/output lines LIO2<1:b>.

In some implementations, during the read operation of the RMW operation, each of the input/output sense amplifiers 331 to 335 may operate in response to an input/out sense activation signal IOSA_EN. The input/out sense activation signal IOSA_EN may correspond to, for example, the first_second read control signal RD_CTRL1_2 (refer to FIGS. 2A and 13A). In addition, the column selection signal selecting one of the column selection lines CSLs during the read operation may correspond to the first_first read control signal RD_CTRL1_1 (refer to FIGS. 2A and 13A).

In some implementations, during the write operation of the RMW operation, each of the drivers 341 to 345 may operate in response to a write drive signal PDT. The write drive signal PDT may correspond to, for example, the first_first write control signal WR_CTRL1_1 (refer to FIGS. 2A and 13A). In addition, the column selection signal selecting one of the column selection lines CSLs during the write operation may correspond to the first_second write control signal WR_CTRL1_2 (refer to FIGS. 2A and 13A).

As described above, the RMW operation of the first bank array 310_1C may be controlled based on the read control signals RD_CTRL1_1 and RD_CTRL_1_2 and the write control signals WR_CTRL1_1 and WR_CTRL_1_2 generated according to the implementations of the present disclosure.

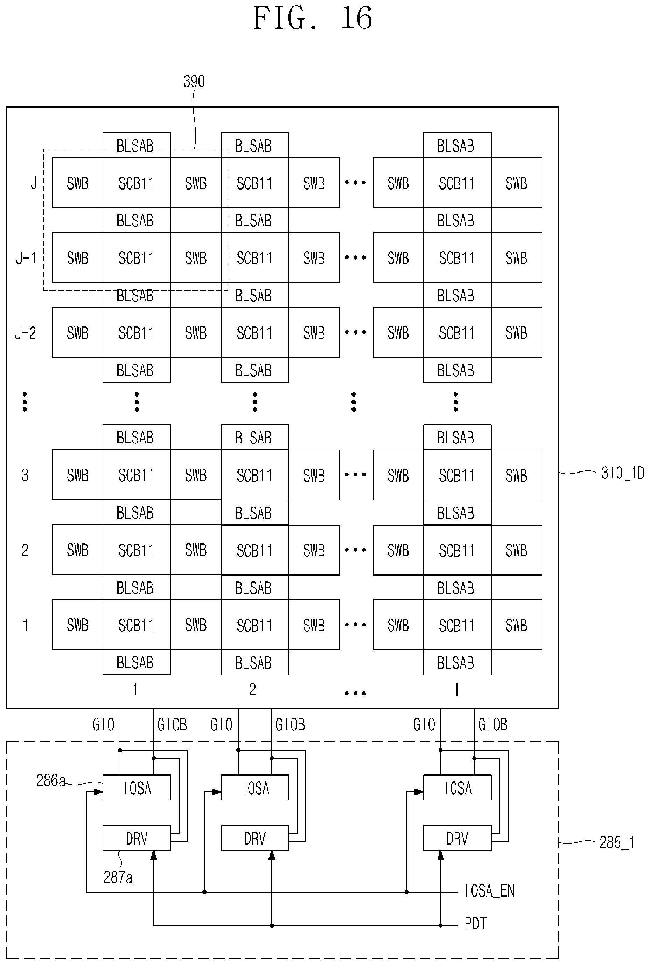

FIG. 16 is a block diagram illustrating an example of a bank array 310_1D and a sense amplifier 285_1. The bank array 310_1D of FIG. 16 may correspond to, for example, one of the first bank arrays of FIGS. 1, 5, and 12. The sense amplifier 285_1 of FIG. 16 may correspond to, for example, the first sense amplifier 285_1 of FIG. 7.

Referring to FIG. 16, a plurality of sub-array blocks SCBs may be disposed in the first bank array 310_1D. The sub-array blocks SCBs may form J columns and I rows (each of I and J being a natural number).

A plurality of bit lines, a plurality of word lines, and memory cells located at points where the bit lines intersect the word lines may be disposed in each sub-array block SCB.

Sub-word line driver areas SWBs may be disposed between the sub-array blocks SCBs. At least one sub-word line driver may be disposed in each sub-word line driver area SWB.

In addition, bit-line sense amplifier areas BLSABs may be disposed between the sub-array blocks SCBs. At least one bit-line sense amplifier may be disposed in each bit-line sense amplifier area BLSAB.

A conjunction area may be disposed adjacent to the sub-word line driver area SWB and the bit-line sense amplifier area BLSAB. As an example, a voltage generator may be disposed in the conjunction area.

The first sense amplifier 285_1 may include a plurality of input/output sense amplifiers (IOSA) 286a and a plurality of drivers (DRV) 287a. Each of the input/output sense amplifiers 286a may be connected to a corresponding sub-array block via corresponding global input/output lines GIO and GIOB. Similarly, each of the drivers 287a may be connected to a corresponding sub-array block via corresponding global input/output lines GIO and GIOB.

In some implementations, an input/out sense activation signal IOSA_EN may be provided to each of the input/output sense amplifiers 286a during the read operation of the RMW operation. The input/out sense activation signal IOSA_EN may correspond to, for example, the first_second read control signal RD_CTRL1_2 (refer to FIGS. 2A and 13A).

In some implementations, a write drive signal PDT may be provided to each of the drivers 287a during the write operation of the RMW. The write drive signal PDT may correspond to, for example, the first_first write control signal WR_CTRL1_1 (refer to FIGS. 2A and 13A).

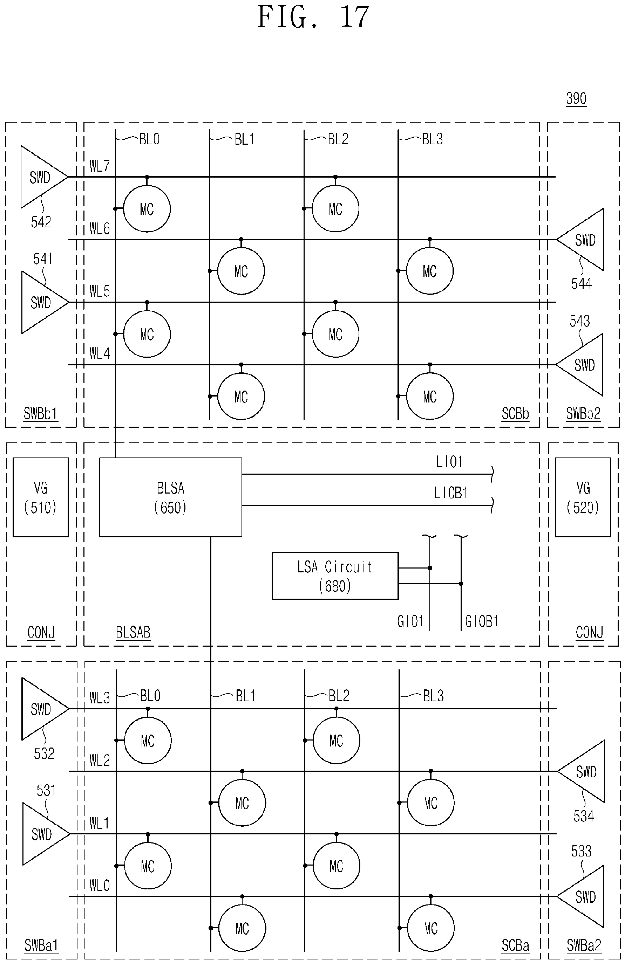

FIG. 17 is a diagram illustrating an example of a portion 390 of the first bank array of FIG. 16 in more detail. For the convenience of explanation, FIG. 17 shows only some of the word lines and some of the bit lines.

Referring to FIGS. 16 and 17, sub-array blocks SCBa and SCBb, the bit-line sense amplifier areas BLSAB, the sub-word line driver areas SWB, and the conjunction areas CONJ may be disposed in the portion 390 of the first bank array 310_1D.

The sub-array block SCBa may include a plurality of word lines WL0 to WL3 extending in a row direction and a plurality of bit lines BL0 to BL3 extending in a column direction and may include memory cells MC located at points where the word lines WL0 to WL3 intersect the bit lines BL0 to BL3.

The sub-array block SCBb may include a plurality of word lines WL4 to WL7 extending in the row direction and of the plural bit lines BL0 to BL3 extending in the column direction and may include memory cells MC located at points where the word lines WL4 to WL7 intersect the bit lines BL0 to BL3.

The sub-word line driver areas SWBa1 and SWBa2 may include sub-word line drivers 531, 532, 533, and 534 to drive the word lines WL1, WL3, WL0, WL2, respectively. The sub-word line driver areas SWBb1 and SWBb2 may include sub-word line drivers 541, 542, 543, and 544 to drive the word lines WL5, WL7, WL4, and WL6, respectively.

The bit-line sense amplifier area BLSAB may include bit-line sense amplifiers 650 connected to the bit line BL0 of the sub-array block SCBa and the bit line BL1 of the sub-array block SCBb in an open bit line structure and a local sense amplifier circuit 680. The bit-line sense amplifier 650 may amplify a difference in level between voltages sensed at the bit lines BL0 and BL1 and may provide the amplified voltage level difference to a local input/output line pair LIO1 and LIOB1.

The conjunction area CONJ may be located adjacent to the bit-line sense amplifier area BLSAB, the sub-word line driver area SWB, and the sub-array block SCB. Voltage generators 510 and 520 may be disposed in the conjunction area CONJ.

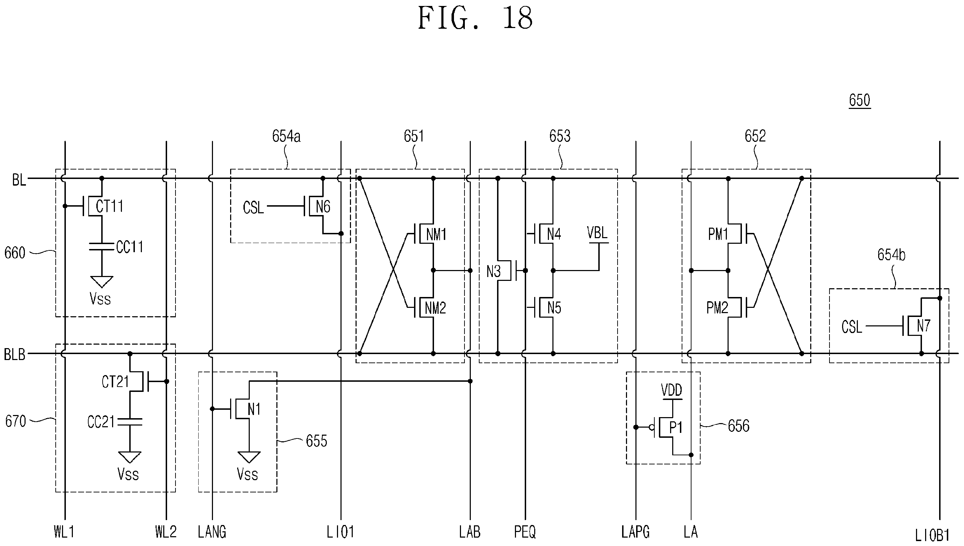

FIG. 18 is a circuit diagram illustrating an example of the bit-line sense amplifier 650 of FIG. 17.

Referring to FIG. 18, the bit line sense amplifier 650 may be connected to bit lines BL and BLB of each of memory cells 660 and 670. The bit line sense amplifier 650 may include an N sense amplifier 651, a P sense amplifier 652, a precharge circuit 653, column selection switches 654a and 654b, an NSA driver 655, and a PSA driver 656.

The N sense amplifier 651 may discharge a low potential bit line of the bit lines BL and BLB during a sensing operation.

The N sense amplifier 651 may include NMOS transistors NM1 and NM2. A gate of the NMOS transistor NM1 may be connected to the bit line BLB, a drain of the NMOS transistor NM1 may be connected to the bit line BL, and a source of the NMOS transistor NM1 may be connected to a sense enable line LAB. A gate of the NMOS transistor NM2 may be connected to the bit line BL, a drain of the NMOS transistor NM2 may be connected to the bit line BLB, and a source of the NMOS transistor NM2 may be connected to the sense enable line LAB.

The N sense amplifier 651 may discharge the low potential bit line to a ground voltage VSS applied to the sense enable line LAB.

The P sense amplifier 652 may charge a high potential bit line of the bit lines BL and BLB with a level of a power supply voltage VDD during the sensing operation.

The P sense amplifier 652 may include PMOS transistors PM1 and PM2. A gate of the PMOS transistor PM1 may be connected to the bit line BLB, a source of the PMOS transistor PM1 may be connected to the bit line BL, and a drain of the PMOS transistor PM1 may be connected to a sense enable line LA. A gate of the PMOS transistor PM2 may be connected to the bit line BL, a source of the PMOS transistor PM2 may be connected to the bit line BLB, and a drain of the PMOS transistor PM2 may be connected to the sense enable line LA.

The P sense amplifier 652 may charge the high potential bit line of the bit lines BL and BLB with the power supply voltage VDD applied to the sense enable line LA.

In this case, a charging voltage VDD may be applied to the sense enable line LA from the PSA driver 656. Then, the transistor PM2 with its gate connected to the bit line BL whose voltage rises due to charge sharing may be turned off.

The precharge circuit 653 may precharge the bit lines BL and BLB to a level of a half-voltage (VDD/2) in response to a control signal PEQ during the sensing operation. When the control signal PEQ is activated, the precharge circuit 653 may apply a bit line precharge voltage VBL to the bit lines BL and BLB for the sensing operation. The precharge circuit 653 may include NMOS transistors N3, N4, and N5.

The column selection switches 654a and 654b may connect data sensed by the N sense amplifier 651 and the P sense amplifier 652 to the local input/output line pair LIO1 and LIOB1. As an example, when the sensing level by the N sense amplifier 651 and the P sense amplifier 652 is stabilized during the read operation, the column selection line CSL may be activated. Then, the column selection switches 654a and 654b may be turned on, and the sensed data may be applied to the local input/output lines LIO1 and LOIB1.

The column selection switches 654a and 654b may include NMOS transistors N6 and N7, respectively.

The NSA driver 655 may apply a driving signal to the sense enable line LAB of the N sense amplifier 651. The NSA driver 655 may receive a control signal LANG from a peripheral circuit 201. The NSA driver 655 may ground the sense enable line LAB in response to the control signal LANG. The NSA driver 655 may include a ground transistor N1 to control a voltage of the sense enable line LAB.

The PSA driver 656 may apply the charging voltage VDD to the sense enable line LA of the P sense amplifier 652. The PSA driver 656 may include a PMOS transistor P1. The PSA driver 656 may be controlled by a control signal LAPG. The control signal LAPG and the control signal LANG may have complementary logic levels.

In some implementations, the column selection line CSL may be activated during the read operation of the RMW operation. In this case, the column selection signal that activates the column selection line CSL may correspond to the first_first read control signal RD_CTRL1_1 (refer to FIGS. 2A and 13A).

In some implementations, the column selection line CSL may be activated during the write operation of the RMW operation. In this case, the column selection signal that activates the column selection line CSL may correspond to the first_second write control signal WR CTRL1 2 (refer to FIGS. 2A and 13A).

As described with reference to FIGS. 16 to 18, the RMW operation of the first bank array 310_1D and the first sense amplifier 285_1 may be controlled based on the read control signals RD_CTRL1_1 and RD_CTRL_1_2 and the write control signals WR_CTRL1_1 and WR_CTRL_1_2, which are generated according to the implementations of the present disclosure.

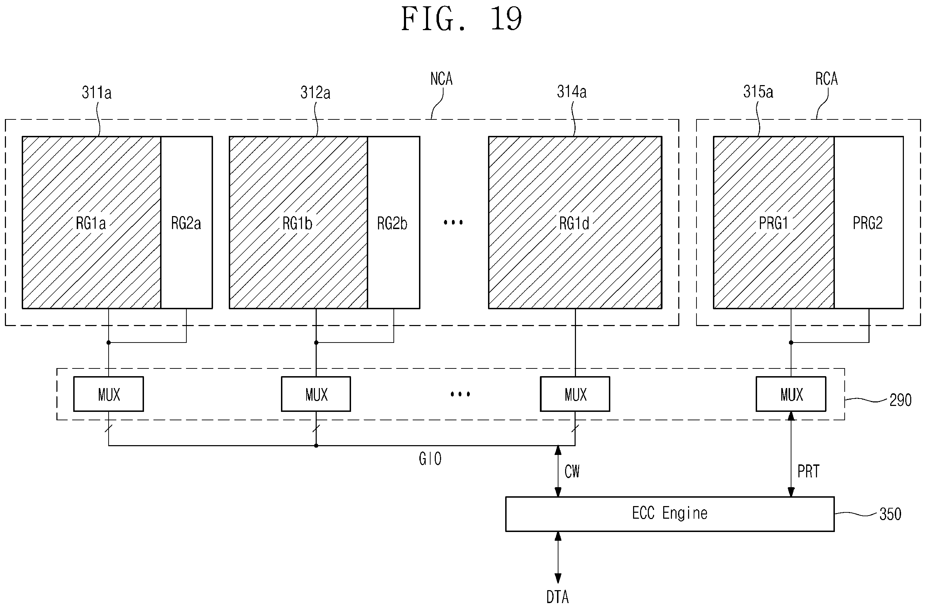

FIG. 19 is a block diagram illustrating an example of a memory device that performs a normal read or write operation. For the convenience of explanation, it is assumed that a bank array of FIG. 19 has substantially the same configuration as that of the first bank array of FIG. 14B.

Referring to FIG. 19, an I/O gating circuit 290 may include a plurality of switching circuits MUX respectively connected to sub-array blocks 311a to 315a.

An ECC engine 350 may be connected to the switching circuits MUX corresponding to the sub-array blocks 311a to 314a via a data line, e.g., global input/output lines, corresponding to a normal cell area NCA. The ECC engine 350 may be connected to the switching circuit MUX corresponding to the sub-array block 315a via a data line corresponding to a redundancy cell area RCA.

In the case of the normal write operation, the memory device 200 (refer to FIG. 1) may receive a write command and data DTA. In this case, the ECC engine 350 may perform an ECC encoding on the data DTA and may generate parity data PRT. Then, the ECC engine 350 may provide a code word CW including the data DTA and the parity data PRT to the I/O gating circuit 290.

The code word CW may be stored in one of the sub-array blocks 311a to 314a of the normal cell area NCA. In this case, the code word CW may be stored in one of first regions RG1a to RG1d of the sub-array blocks 311a to 314a. In addition, the parity data PRT may be stored in the sub-array block 315a of the redundancy cell area RCA. In this case, the parity data PRT may be stored in a first region PRG1 of the sub-array block 315a.

In the normal read operation, the memory device 200 may receive the read command. In this case, the code word CW stored in one of the sub-array blocks 311a to 314a of the normal cell area NCA may be provided to the ECC engine 350 via the I/O gating circuit 290. In addition, the parity data PRT stored in the sub-array block 315a of the redundancy cell area RCA may be provided to the ECC engine 350 via the I/O gating circuit 290. The ECC engine 350 may decode the code word CW based on the parity data PRT to generate the data DTA.

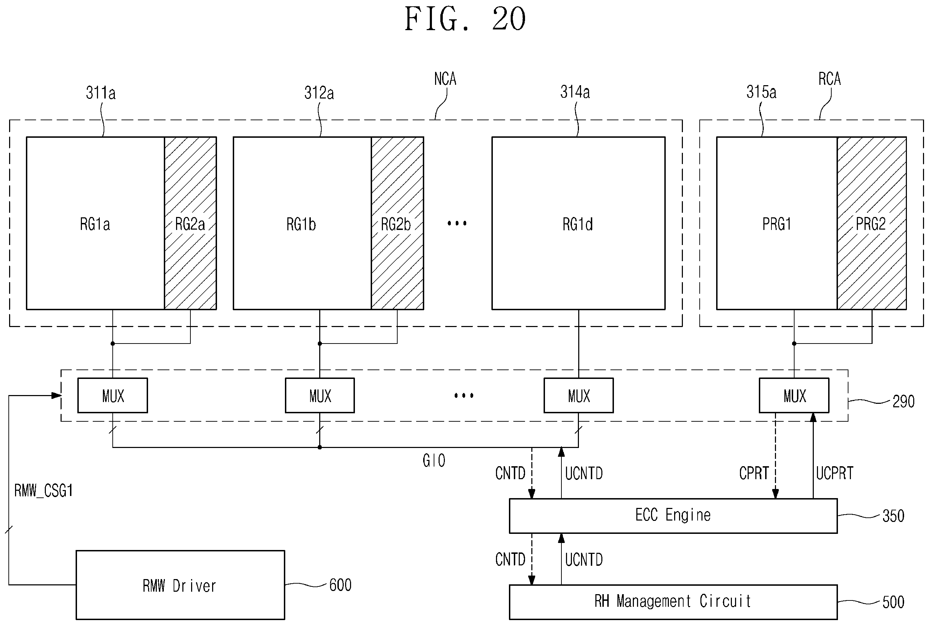

FIG. 20 is a block diagram illustrating an example of a memory device that performs an RMW operation. For the convenience of explanation, it is assumed that a bank array of FIG. 20 has substantially the same configuration as that of the first bank array of FIG. 14B. In addition, it is assumed that a first precharge command PRE1 is received after a normal read operation or write operation is performed on a first bank array.

When the first precharge command PRE1 is received, an RMW driver 600 may generate a first RMW core signal group RMW_CSG1 based on the first precharge command PRE1. As an example, an IACU generator 610 (refer to FIG. 10) of the RMW driver 600 may generate a first internal active count update signal IACU1 (refer to FIG. 10) based on the first precharge command PRE1, and a first RMW control circuit 620_1 (refer to FIG. 10) of the RMW driver 600 may generate the first RMW core signal group RMW_CSG1 based on the first internal active count update signal IACU1. The first RMW core signal group RMW_CSG1 may be provided to the I/O gating circuit 290 and the first bank array.

Then, the read operation of the RMW operation may be performed.

As an example, a count data CNTD for each memory cell row may be stored in second regions RG1a to RG1d of sub-array blocks 311a to 314a, and count parity data CPRT related to the count data CNTD may be stored in a second region PRG2 of a sub-array block 315a.

In this case, the count data CNTD corresponding to a target memory cell row may be read out from the second regions RG1a to RG1d of the sub-array blocks 311a to 314a, and the read-out count data CNTD may be provided to the ECC engine 350. In addition, the count parity data corresponding to the target memory cell row may be read out from the second region PRG2 of the sub-array block 315a, and the read-out count parity data CPRT may be provided to the ECC engine 350. The ECC engine 350 may perform an ECC decoding operation on the count data CNTD and the count parity data CPRT to correct an error bit of the count data CNTD and may provide the count data CNTD to a row hammer management circuit 500.

Then, a correction operation of the RMW operation may be performed.

As an example, the row hammer management circuit 500 may perform an updating operation to increase the count data CNTD by ` 1'.

Then, the write operation of the RMW operation may be performed.

As an example, the row hammer management circuit 500 may provide the updated count data UCNTD to the ECC engine 350. The ECC engine 350 may perform an ECC encoding operation on the updated count data UCNTD to generate updated count parity data UCPRT. The updated count data UCNTD may be stored again in a count cell corresponding to an activated memory cell row among the count cells of the second regions RG2a to RG2c of a normal cell area NCA. The updated count parity data UCPRT may be stored again in the memory cell corresponding to the activated memory cell row among the memory cells of the second region PRG2 of the redundancy cell area RCA.

As described above, as the memory device according to the present disclosure supports the RMW operation, the number of accesses to each of the memory cell rows may be accurately managed. Accordingly, the row hammer phenomenon that occurs due to the intensive access to a specific memory cell row may be prevented in advance.

In addition, the memory device according to the present disclosure may perform the RMW operation based on the precharge command, and RMW operation may be performed in parallel. Accordingly, the RMW operation may be performed without degrading the performance and increasing the complexity of protocol between the host and the memory device 200.

Meanwhile, the memory devices 200 shown in FIGS. 7 and 20 are described as including the ECC engine. As the memory device 200 includes the ECC engine, the memory device 200 according to the present disclosure may accurately manage the count data for each memory cell row even when the active count update time tACU is set relatively short, however, this is merely an example. In some implementations, the memory device 200 may not include the ECC engine.

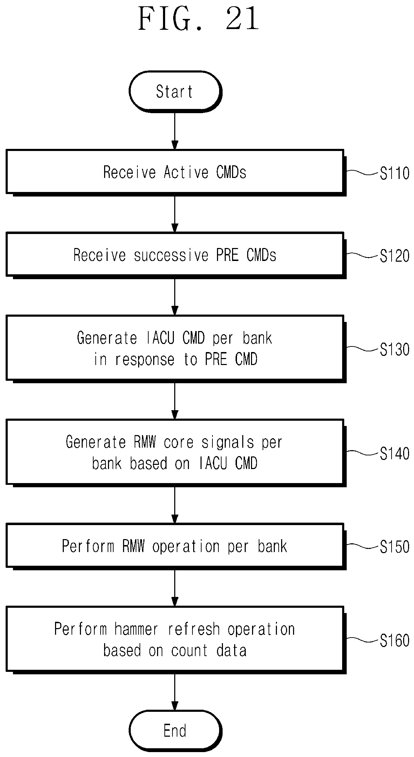

FIG. 21 is a flowchart illustrating an example of an operation of a memory device. The memory device described with reference to FIG. 21 may be one of the memory devices described with reference to FIGS. 1 to 20.

In operation S110, the memory device may receive the active commands ACT from the host.

As an example, the memory device may include the plural banks and may receive the active commands ACTs for each of the banks. In this case, the normal read or write operation may be performed on each bank.

In operation S120, the memory device may continuously receive the precharge commands PREs from the host.

As described with reference to FIG. 3, the precharge commands PREs transmitted from the host to the memory device may be transmitted earlier than the normal precharge command by the active count update time tACU.

In operation S130, the memory device may generate the internal active count update signals IACUs for each of the banks based on the precharge commands PREs.

In this case, as described with reference to FIG. 13B, the memory device may generate the internal active count update signal IACU for each bank. In addition, at least some of the activated sections of different internal active count update signals IACUs corresponding to different banks may overlap with each other.

In operation S 140, the memory device may generate the RMW core signal group RMW_CSG for each bank based on the internal active count update signals IACUs.

In operation S150, the memory device may perform the RMW operation on each bank based on the RMW core signal group RMW_CSG for each bank.

In this case, the RMW operation for each bank may be performed in parallel. That is, the RMW operations for different banks may be performed substantially simultaneously. Accordingly, the RMW operation may be performed on each bank without degrading the performance.

In operation S 160, the hammer refresh operation may be performed based on the count data or the updated count data.

As an example, in the case where a value of the updated count data generated by the RMW operation is greater than a predetermined value, the memory device may determine that the target memory cell row is the aggressor memory cell row. In this case, the memory device may perform the hammer refresh operation on the adjacent memory cell row. Accordingly, the row hammer phenomenon may be prevented in advance.

As described above, the memory device according to the present disclosure may manage the number of accesses to each of the memory cell rows through the RMW operation. In particular, the memory device according to the present disclosure may perform the RMW operation based on the precharge command without the need to define a separate dedicated command for the RMW operation. Accordingly, the RMW operation may be performed without degrading the performance and increasing the complexity of protocol between the memory controller 100 and the memory device 200.

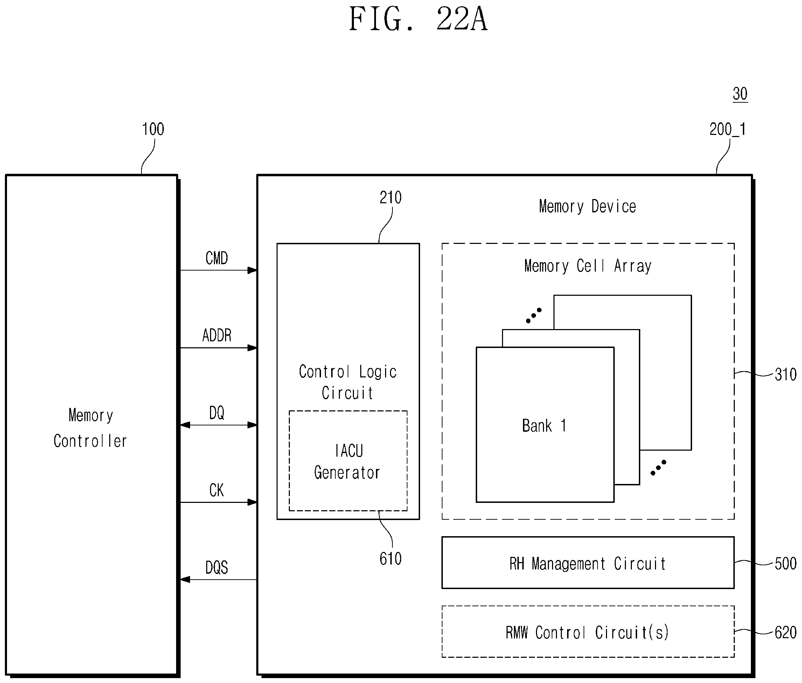

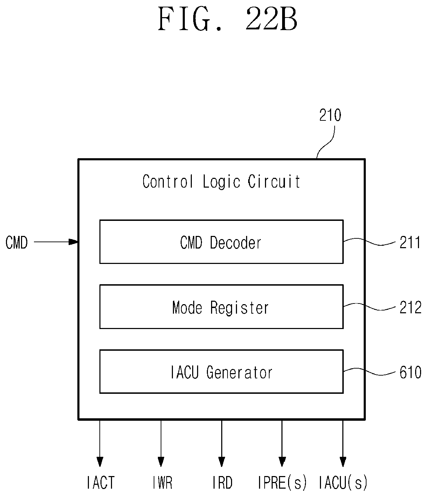

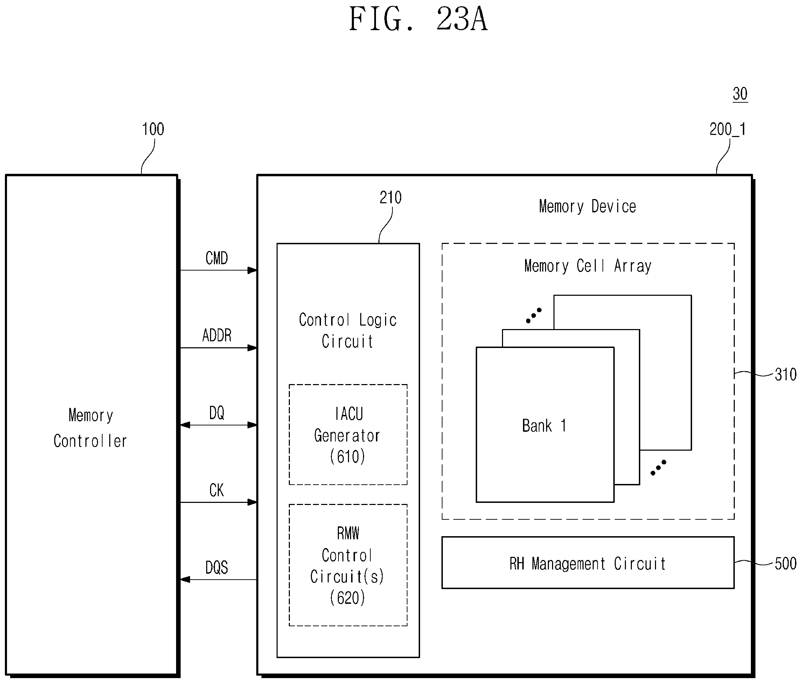

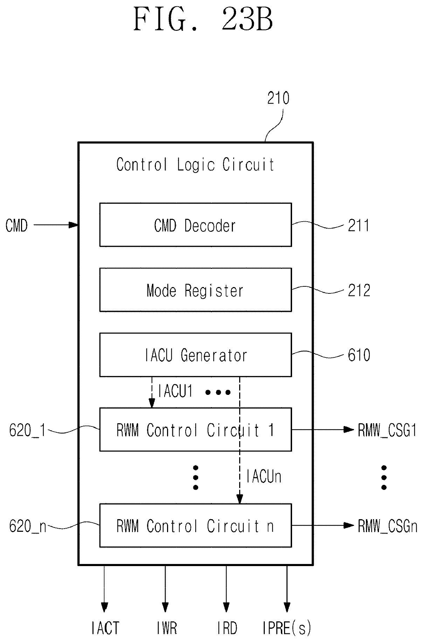

Meanwhile, in FIGS. 5 to 21, the RMW driver is described as being independently implemented from the control logic circuit, however, this is merely an example, and the present disclosure should not be limited thereto or thereby. As an example, a portion or all of the RMW driver may be implemented integrated with the control logic circuit. This will be described in detail with reference to FIGS. 22A, 22B, 23A, and 23B.

FIG. 22A is a block diagram illustrating an example of a memory system 30.

FIG. 22B is a block diagram illustrating an example of a control logic circuit 210 of FIG. 22A in more detail. The memory system 30 of FIG. 22A is similar to the memory system 20 of FIG. 5. In FIG. 22A, the same reference numerals denote the same elements in FIG. 5, and thus, detailed descriptions of the same elements will be omitted.

Different from the implementation of FIG. 5 in which the RMW driver and the control logic circuit are implemented independently from each other, at least a portion of the RMW driver may be implemented integrated with the control logic circuit 210 in FIG. 22A.

As an example, as shown in FIG. 22A, an IACU generator 610 may be implemented as a portion of the control logic circuit 210, and an RMW control circuits 620 may be implemented independently from the control logic circuit 210 as a separate circuit.

In this case, as shown in FIG. 22B, the control logic circuit 210 may include a command decoder 211, a mode register 212, and the IACU generator 610, and the control logic circuit 210 may generate an internal active signal IACT, an internal write signal IWR, an internal read signal IRD, an internal precharge signal IPRE, and an internal active count update signal IACU based on a command CMD received from a memory controller 100.

FIG. 23A is a block diagram illustrating an example of a memory system 30.

FIG. 23B is a block diagram illustrating an example of a control logic circuit 210 of FIG. 23A in more detail. The memory system 30 of FIG. 23A is similar to the memory system 20 of FIG. 5. In FIG. 23A, the same reference numerals denote the same elements in FIG. 5, and thus, detailed descriptions of the same elements will be omitted.

FIG. 23A shows a structure in which all components of an RMW driver are implemented integrated with the control logic circuit 210. As an example, as shown in FIG. 23A, an IACU generator 610 and RMW control circuits 620 may be implemented as portions of the control logic circuit 210.

In this case, as shown in FIG. 23B, the control logic circuit 210 may include a command decoder 211, a mode register 212, the IACU generator 610, and of the plural RMW control circuits 620_1 to 620_n. The control logic circuit 210 may generate an internal active signal IACT, an internal write signal IWR, an internal read signal IRD, and an internal precharge signal IPRE based on a command CMD received from a memory controller 100.

In addition, the control logic circuit 210 may generate a plurality of internal active count update signals IACU1 to IACUn based on a precharge command PREs and may generate RMW core signal groups RMW_CSG1 to RMW_CSGn for each bank based on the internal active count update signals IACU1 to IACUn.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A memory device (200) comprising:
a memory cell array (310) comprising a plurality of memory cell rows, the memory cell array (310) configured to store count data (CNTD) for a number of accesses to each memory cell row of the plurality of memory cell rows;
a row hammer management circuit (500) configured to:
perform a read-modify-write, RMW, operation that reads out count data (CNTD) corresponding to a target memory cell row among the plurality of memory cell rows,
update the read-out count data, and
write the updated read-out count data in the memory cell array (310); and
an RMW driver (600, 600A, 600B) configured to generate a plurality of RMW control signals, wherein the RMW driver (600, 600A, 600B) is configured to generate the plurality of RMW control signals (RD_CTRL, WR CTRL) based on a precharge command (PRE), and the target memory cell row is precharged after a predetermined time (tACU) is elapsed from a time point where the precharge command (PRE) is applied.

2. The memory device (200) of claim 1, wherein the RMW operation with respect to the target memory cell row and a precharge operation with respect to the target memory cell row are performed based on the precharge command (PRE).

3. The memory device (200) of claim 1 or 2, wherein the RMW operation with respect to the target memory cell row is performed based on the precharge command (PRE) during an active count update time (tACU), and the target memory cell row is precharged based on the precharge command (PRE) after the active count update time (tACU) is elapsed from the time point where the precharge command (PRE) is applied.

4. The memory device (200) of any one of claims 1 to 3, wherein the memory cell array (310) comprises a first bank and a second bank comprising the plurality of memory cell rows, and wherein the RMW driver (600, 600A, 600B) is configured to:
receive a first precharge command (PRE1) corresponding to the first bank,
receive a second precharge command (PREn) corresponding to the second bank,
generate a first internal active count update signal (IACU1) corresponding to the first bank based on the first precharge command (PRE1), and
generate a second internal active count update signal (IACU2) corresponding to the second bank based on the second precharge command (PREn).

5. The memory device (200) of claim 4, wherein a section in which the first internal active count update signal (IACU1) corresponding to the first bank is activated overlaps a section in which the second internal active count update signal (IACU2) corresponding to the second bank is activated.

6. The memory device (200) of claim 4 or 5, wherein the RMW driver (600, 600A, 600B) is configured to:
generate a first RMW core signal group (RMW_CSG1) that controls an RMW operation of the first bank based on the first internal active count update signal (IACU1), and
generate a second RMW core signal group (RMW_CSG2) that controls an RMW operation of the second bank based on the second internal active count update signal (IACU2).

7. The memory device (200) of any one of claims 1 to 6, wherein the RMW driver (600, 600A, 600B) comprises:
an internal active count update signal generator (610) configured to generate, based on the precharge command (PRE), an internal active count update signal (IACU) with respect to a bank (29, 32) corresponding to the precharge command (PRE); and
an RMW control circuit (620) configured to generate, based on the internal active count update signal (IACU), an RMW core signal group (RMW_CSG) that controls an RMW operation of the bank corresponding to the precharge command (PRE).

8. The memory device (200) of claim 7, wherein the internal active count update signal generator (610) is configured to maintain a level of the internal active count update signal (IACU) at a high level during the predetermined time (tACU).

9. The memory device (200) of claim 8, wherein the RMW control circuit (620) comprises:
an oscillator (620_1a) configured to generate an oscillation signal (OSC) during the high level of the internal active count update signal (IACU); and
a core signal generator (620_1b) configured to generate, based on a rising edge or a falling edge of the oscillation signal (OSC), the RMW core signal group (RMW_CSG) that controls the RMW operation of the bank corresponding to the precharge command (PRE).

10. The memory device (200) of claim 9, wherein the oscillation signal (OSC) has a frequency that changes as an operation frequency of the memory device changes.

11. The memory device (200) of any one of claims 1 to 10, comprising a control logic circuit (210, 210m) configured to generate, based on the precharge command (PRE), an internal precharge signal that precharges the target memory cell row after the predetermined time (tACU) is elapsed from the time point where the precharge command (PRE) is applied.

12. The memory device (200) of any one of claims 1 to 11, wherein the row hammer management circuit (500) is configured to perform a refresh operation on a memory cell row adjacent to the target memory cell row based on a value of the updated read-out count data being equal to or greater than a predetermined value.

13. The memory device (200) of any one of claims 1 to 12, comprising an ECC engine (350) configured to perform an error correction operation on the read-out count data.

14. A method of operating a memory device (200), comprising:
receiving (S10) an active command (ACT) corresponding to a target memory cell row among a plurality of memory cell rows;
receiving (S20) a precharge command (PRE) corresponding to the target memory cell row;
generating (S30), based on the precharge command (PRE), an internal active count update signal (IACU) corresponding to the target memory cell row;
generating (S40), based on the internal active count update signal (IACU), a plurality of control signals (RD_CTRL, WR CTRL) that update count data (CNTD) with respect to the target memory cell row; and
performing (S50), based on the precharge command (PRE), a precharge operation on the target memory cell row after an active count update time (tACU) is elapsed.

15. The method of claim 14, comprising performing a read-modify-write, RMW, operation, wherein the RMW operation reads out count data (CNTD) corresponding to the target memory cell row during the active count update time (tACU), updates the read-out count data, and writes the updated read-out count data in a memory cell array (310).
